# EUROPEAN PATENT SPECIFICATION

(11) **EP 4 472 375 B1**
(45) Date of publication and mention of the grant of the patent: **10.06.2026**
(21) Application number: 24730854.7
(22) Date of filing: 19.04.2024
(51) Int. Cl.: G06F 1/20, H04M 1/02, F28D 15/02, F28D 15/04, H05K 7/20

(54) **ELECTRONIC DEVICE COMPRISING HEAT DISSIPATION MEMBER**
ELEKTRONISCHE VORRICHTUNG MIT WÄRMEABLEITUNGSELEMENT
DISPOSITIF ÉLECTRONIQUE COMPRENANT UN ÉLÉMENT DE DISSIPATION DE CHALEUR

(30) Priority: 19.04.2023 KR 20230051517; 30.08.2023 KR 20230114763
(43) Date of publication of application: 04.12.2024
(73) Proprietor: Samsung Electronics Co., Ltd., Suwon-si, Gyeonggi-do 16677 (KR)
(72) Inventor: AHN, Joseph, Suwon-si, Gyeonggi-do 16677 (KR); LEE, Haejin, Suwon-si, Gyeonggi-do 16677 (KR)
(74) Representative: Nederlandsch Octrooibureau
(86) International application number: PCT/KR2024/005303
(87) International publication number: WO 2024/219879

(56) References cited:
- KR-A- 20040 058 095
- KR-A- 20050 013 402
- KR-A- 20140 031 358
- KR-A- 20220 064 139
- KR-A- 20230 013 964
- US-A- 5 764 483
- US-A1- 2019 257 589
- US-A1- 2020 100 390
- US-A1- 2022 312 639

## Description

### [Technical Field]

Embodiments disclosed herein relate to an electronic device including a heat dissipation member.

### [Background Art]

With the advancement of technology, high-performance electronic components are being placed inside electronic devices. Electronic components may generate heat when operating. Heat generated from electronic components may reduce the performance of electronic components. Accordingly, an electronic device may include a structure that dissipates heat generated from an electronic component to surroundings. For example, a structure that is in contact with an electronic component to dissipate heat to the surroundings, such as a vapor chamber or a heat pipe, may be disposed inside an electronic device. In addition, various types of heat dissipation structures are being designed in electronic devices to dissipate heat from electronic components to surroundings.

Known heat dissipation structures for electronic devices are known from documents US 2019/257589 A1 and US 5 764 483 A.

The above-mentioned information may be provided as a related art for the purpose of helping understanding of the disclosure. No claim or determination is made as to whether any of the foregoing may be applied as a prior art related to the disclosure.

### [Disclosure of Invention]

### [Technical Problem]

Electronic components that generate high heat, such as an application processor (AP), may be placed inside the electronic device. In an embodiment, when a heat dissipation member is in contact with an electronic device, heat generated by the electronic component may be distributed to the surroundings. For example, when a vapor chamber placed inside an electronic device is in contact with an electronic component, heat generated from the electronic component may be distributed to the surroundings.

Meanwhile, when a heat dissipation member is placed in an electronic device, the thickness of a housing of the electronic device may be reduced by the space occupied by the heat dissipation member. For example, the housing may be processed in the thickness direction of the housing such that the heat dissipation member can be fixed. In this case, the rigidity of the housing may be weakened and the housing may be easily damaged by external impact.

According to an embodiment of the disclosure, it is possible to provide a heat dissipation structure that minimizes processing on the housing and increases an area for heat dissipation within an electronic device.

The technical problems to be addressed by this disclosure are not limited to those described above, and other technical problems, which are not described above, may be clearly understood by a person ordinarily skilled in the related art to which the disclosure belongs.

### [Solution to Problem]

According to the invention as defined in claim 1, an electronic device comprises a first housing comprising a front surface, a rear surface opposite to the front surface and a side surface surrounding a space between the front surface and the rear surface,a first electronic component disposed at a first seating portion of the first housing;a first battery disposed at a second seating portion of the first housing; and a first heat dissipation member comprising:a first heat exchanger disposed at the first seating portion, the first heat exchanger being, in contact with the first electronic component and adjacent to a first side of the first battery,a second heat exchanger disposed at the second seating portion and adjacent to a second side of the first battery, the second side being opposite to the first side of the first battery,a vapor pipe disposed at the second seating portion and adjacent to a third side of the first battery, the third side being perpendicular to the first side of the first battery, the vapor pipe being configured to transfer vapor generated at the first heat exchanger to the second heat exchanger, and a liquid pipe disposed at the second seating portion and adjacent to a fourth side of the first battery, the fourth side being opposite to the third side of the first battery, the liquid pipe being configured to transfer liquid generated at the second heat exchanger to the first heat exchanger.

According to a comparative example useful for understanding the invention but outside the scope of the invention as claimed, an electronic device may include a housing including a seating portion on which an electronic component is placed, a (1-1)^{th} inner wall facing the seating portion, a (1-2)^{th} inner wall located between the seating portion and the first inner wall, and a (1-3)^{th} inner wall facing the (1-2)^{th} inner wall; and a heat dissipation member which is at least partially in contact with the first electronic component, wherein the heat dissipation member may include a first heat exchanger which is in contact with the first electronic component, a second heat exchanger which is located inside the (1-1)^{th} inner wall, a vapor pipe which is located inside the (1-2)^{th} inner wall and interconnects the first heat exchanger and the second heat exchanger, and a liquid pipe which is located inside the (1-3)^{th} inner wall and interconnects the first heat exchanger and the second heat exchanger.

Further advantageous features are defined in the dependent claims.

### [Advantageous Effects of Invention]

According to an embodiment of the disclosure, it is possible to provide a heat dissipation structure that minimizes processing on the housing and increases an area for heat dissipation within an electronic device. For example, a loop heat pipe, which is in contact with an electronic component may be disposed inside an electronic device. Since the loop heat pipe is disposed along a lateral inner wall of the housing, processing of the housing in the thickness direction may not be necessary. Therefore, a predetermined level of rigidity of the housing can be ensured.

The effects that are capable of being obtained by the disclosure are not limited to those described above, and other effects not described above may be clearly understood by a person ordinarily skilled in the art to which the disclosure belongs based on the following description.

### [Brief Description of Drawings]

In connection with the description of the drawings, the same or similar components may be denoted by the same or similar reference numerals.
FIG. 1 illustrates a block diagram of an electronic device according to various embodiments of the disclosure in a network environment.
FIG. 2A illustrates a front perspective view of an electronic device according to an embodiment of the disclosure.
FIG. 2B illustrates a rear perspective view of the electronic device of FIG. 2A according to an embodiment of the disclosure.
FIG. 3 illustrates an exploded perspective view of the electronic device of FIG. 2A, according to an embodiment of the disclosure.
FIG. 4A illustrates a perspective view of a heat dissipation member disposed inside an electronic device according to an embodiment of the disclosure.
FIG. 4B illustrates an enlarged view of a first heat exchanger of the heat dissipation member according to an embodiment of the disclosure.
FIG. 5A is a view illustrating a state in which the first heat exchanger of the heat dissipation member according to an embodiment of the disclosure is arranged in the housing.
FIG. 5B is a view illustrating a state in which the second heat exchanger, the vapor pipe, and the liquid pipe of the heat dissipation member of FIG. 5A are arranged.
FIG. 5C illustrates an enlarged view of a first opening through which a portion of the heat dissipation member of FIGS. 5A and 5B passes.
FIG. 6 illustrates a view of a state in which a heat dissipation member is disposed on one surface of a housing according to an embodiment of the disclosure, and an enlarged view of a second opening through which a portion of the heat dissipation member passes through a partition wall of the housing.
FIG. 7 is a view illustrating a state in which a portion of the heat dissipation member is disposed inside the inner wall of the housing according to an embodiment of the disclosure.
FIG. 8A illustrates a cross-sectional view of the vapor pipe of the heat dissipation member according to an embodiment of the disclosure.
FIG. 8B illustrates a cross-sectional view of the liquid pipe of the heat dissipation member according to an embodiment of the disclosure.
FIG. 8C illustrates a cross-sectional view of the vapor pipe of the heat dissipation member according to an embodiment of the disclosure.
FIG. 8D illustrates a cross-sectional view of the liquid pipe of the heat dissipation member according to an embodiment of the disclosure.
FIG. 9 is a view illustrating the heat dissipation performance of the heat dissipation member according to an embodiment of the disclosure.
FIG. 10 is a view illustrating a state in which the heat dissipation member is disposed in the first housing according to an embodiment of the disclosure.
FIG. 11 is a view illustrating a state in which a portion of the first heat dissipation member placed in the first housing and a portion of the second heat dissipation member, which is at least partially placed in the second housing, are in contact with electronic components arranged in the first housing according to an embodiment of the disclosure.
FIGS. 12A and 12B are views illustrating a state in which the first heat dissipation member placed in the first housing and the second heat dissipation member placed in the second housing are connected to each other via a connection portion located in the folding area.
FIGS. 13A to 13C are views illustrating various embodiments of the connection portion according to an embodiment of the disclosure.
FIG. 14 is a view illustrating a state in which the first heat dissipation member placed in the first housing and the second heat dissipation member placed in the second housing are connected to each other via a third connection portion located in the folding area.

### [Mode for the Invention]

It should be appreciated that various embodiments of the present disclosure and the terms used therein are not intended to limit the technological features set forth herein to particular embodiments and include various changes, or replacements for a corresponding embodiment as long as the resulting subject-matter still falls under the scope of the appended claims.

With regard to the description of the drawings, similar reference numerals may be used to refer to similar or related elements. It is to be understood that a singular form of a noun corresponding to an item may include one or more of the things, unless the relevant context clearly indicates otherwise.

As used herein, each of such phrases as "A or B," "at least one of A and B," "at least one of A or B," "A, B, or C," "at least one of A, B, and C," and "at least one of A, B, or C," may include any one of, or all possible combinations of the items enumerated together in a corresponding one of the phrases. As used herein, such terms as "1st" and "2nd," or "first" and "second" may be used to simply distinguish a corresponding component from another, and does not limit the components in other aspect (e.g., importance or order). It is to be understood that if an element (e.g., a first element) is referred to, with or without the term "operatively" or "communicatively", as "coupled with," "coupled to," "connected with," or "connected to" another element (e.g., a second element), it means that the element may be coupled with the other element directly (e.g., wiredly), wirelessly, or via a third element.

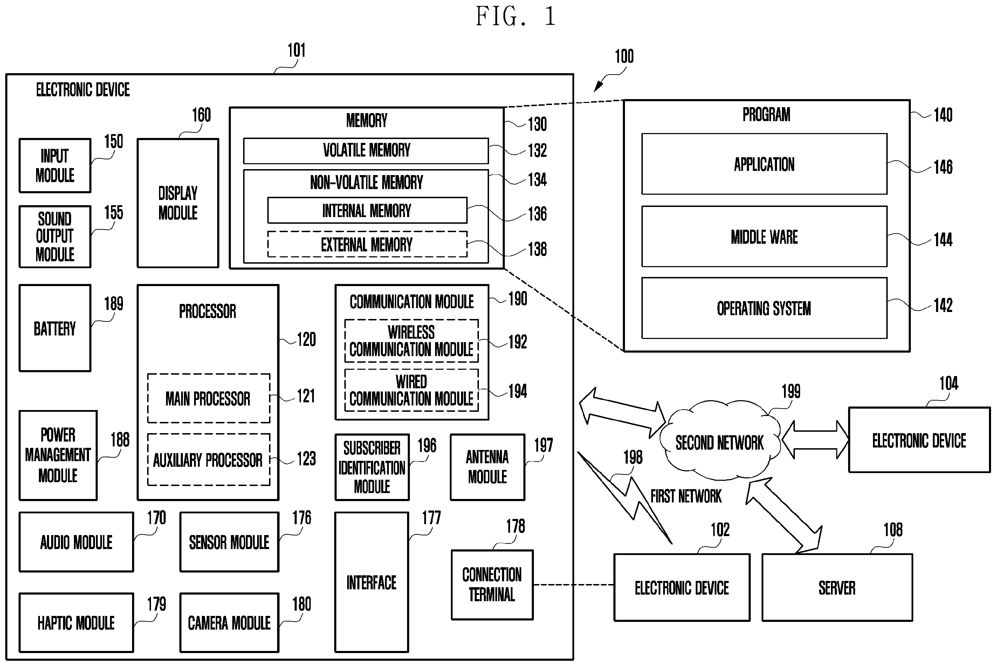

Fig. 1 is a block diagram illustrating an electronic device 101 in a network environment 100 according to various embodiments. Referring to Fig. 1, the electronic device 101 in the network environment 100 may communicate with an electronic device 102 via a first network 198 (e.g., a short-range wireless communication network), or at least one of an electronic device 104 or a server 108 via a second network 199 (e.g., a long-range wireless communication network). According to an embodiment, the electronic device 101 may communicate with the electronic device 104 via the server 108. According to an embodiment, the electronic device 101 may include a processor 120, memory 130, an input module 150, a sound output module 155, a display module 160, an audio module 170, a sensor module 176, an interface 177, a connecting terminal 178, a haptic module 179, a camera module 180, a power management module 188, a battery 189, a communication module 190, a subscriber identification module(SIM) 196, or an antenna module 197. In some embodiments, at least one of the components (e.g., the connecting terminal 178) may be omitted from the electronic device 101, or one or more other components may be added in the electronic device 101. In some embodiments, some of the components (e.g., the sensor module 176, the camera module 180, or the antenna module 197) may be implemented as a single component (e.g., the display module 160).

The processor 120 may execute, for example, software (e.g., a program 140) to control at least one other component (e.g., a hardware or software component) of the electronic device 101 coupled with the processor 120, and may perform various data processing or computation. According to one embodiment, as at least part of the data processing or computation, the processor 120 may store a command or data received from another component (e.g., the sensor module 176 or the communication module 190) in volatile memory 132, process the command or the data stored in the volatile memory 132, and store resulting data in non-volatile memory 134. According to an embodiment, the processor 120 may include a main processor 121 (e.g., a central processing unit (CPU) or an application processor (AP)), or an auxiliary processor 123 (e.g., a graphics processing unit (GPU), a neural processing unit (NPU), an image signal processor (ISP), a sensor hub processor, or a communication processor (CP)) that is operable independently from, or in conjunction with, the main processor 121. For example, when the electronic device 101 includes the main processor 121 and the auxiliary processor 123, the auxiliary processor 123 may be adapted to consume less power than the main processor 121, or to be specific to a specified function. The auxiliary processor 123 may be implemented as separate from, or as part of the main processor 121.

The auxiliary processor 123 may control at least some of functions or states related to at least one component (e.g., the display module 160, the sensor module 176, or the communication module 190) among the components of the electronic device 101, instead of the main processor 121 while the main processor 121 is in an inactive (e.g., sleep) state, or together with the main processor 121 while the main processor 121 is in an active state (e.g., executing an application). According to an embodiment, the auxiliary processor 123 (e.g., an image signal processor or a communication processor) may be implemented as part of another component (e.g., the camera module 180 or the communication module 190) functionally related to the auxiliary processor 123. According to an embodiment, the auxiliary processor 123 (e.g., the neural processing unit) may include a hardware structure specified for artificial intelligence model processing. An artificial intelligence model may be generated by machine learning. Such learning may be performed, e.g., by the electronic device 101 where the artificial intelligence is performed or via a separate server (e.g., the server 108). Learning algorithms may include, but are not limited to, e.g., supervised learning, unsupervised learning, semi-supervised learning, or reinforcement learning. The artificial intelligence model may include a plurality of artificial neural network layers. The artificial neural network may be a deep neural network (DNN), a convolutional neural network (CNN), a recurrent neural network (RNN), a restricted boltzmann machine (RBM), a deep belief network (DBN), a bidirectional recurrent deep neural network (BRDNN), deep Q-network or a combination of two or more thereof but is not limited thereto. The artificial intelligence model may, additionally or alternatively, include a software structure other than the hardware structure.

The memory 130 may store various data used by at least one component (e.g., the processor 120 or the sensor module 176) of the electronic device 101. The various data may include, for example, software (e.g., the program 140) and input data or output data for a command related thererto. The memory 130 may include the volatile memory 132 or the non-volatile memory 134.

The program 140 may be stored in the memory 130 as software, and may include, for example, an operating system (OS) 142, middleware 144, or an application 146.

The input module 150 may receive a command or data to be used by another component (e.g., the processor 120) of the electronic device 101, from the outside (e.g., a user) of the electronic device 101. The input module 150 may include, for example, a microphone, a mouse, a keyboard, a key (e.g., a button), or a digital pen (e.g., a stylus pen).

The sound output module 155 may output sound signals to the outside of the electronic device 101. The sound output module 155 may include, for example, a speaker or a receiver. The speaker may be used for general purposes, such as playing multimedia or playing record. The receiver may be used for receiving incoming calls. According to an embodiment, the receiver may be implemented as separate from, or as part of the speaker.

The display module 160 may visually provide information to the outside (e.g., a user) of the electronic device 101. The display module 160 may include, for example, a display, a hologram device, or a projector and control circuitry to control a corresponding one of the display, hologram device, and projector. According to an embodiment, the display module 160 may include a touch sensor adapted to detect a touch, or a pressure sensor adapted to measure the intensity of force incurred by the touch.

The audio module 170 may convert a sound into an electrical signal and vice versa. According to an embodiment, the audio module 170 may obtain the sound via the input module 150, or output the sound via the sound output module 155 or a headphone of an external electronic device (e.g., an electronic device 102) directly (e.g., wiredly) or wirelessly coupled with the electronic device 101.

The sensor module 176 may detect an operational state (e.g., power or temperature) of the electronic device 101 or an environmental state (e.g., a state of a user) external to the electronic device 101, and then generate an electrical signal or data value corresponding to the detected state. According to an embodiment, the sensor module 176 may include, for example, a gesture sensor, a gyro sensor, an atmospheric pressure sensor, a magnetic sensor, an acceleration sensor, a grip sensor, a proximity sensor, a color sensor, an infrared (IR) sensor, a biometric sensor, a temperature sensor, a humidity sensor, or an illuminance sensor.

The interface 177 may support one or more specified protocols to be used for the electronic device 101 to be coupled with the external electronic device (e.g., the electronic device 102) directly (e.g., wiredly) or wirelessly. According to an embodiment, the interface 177 may include, for example, a high definition multimedia interface (HDMI), a universal serial bus (USB) interface, a secure digital (SD) card interface, or an audio interface.

A connecting terminal 178 may include a connector via which the electronic device 101 may be physically connected with the external electronic device (e.g., the electronic device 102). According to an embodiment, the connecting terminal 178 may include, for example, a HDMI connector, a USB connector, a SD card connector, or an audio connector (e.g., a headphone connector).

The haptic module 179 may convert an electrical signal into a mechanical stimulus (e.g., a vibration or a movement) or electrical stimulus which may be recognized by a user via his tactile sensation or kinesthetic sensation. According to an embodiment, the haptic module 179 may include, for example, a motor, a piezoelectric element, or an electric stimulator.

The camera module 180 may capture a still image or moving images. According to an embodiment, the camera module 180 may include one or more lenses, image sensors, image signal processors, or flashes.

The power management module 188 may manage power supplied to the electronic device 101. According to one embodiment, the power management module 188 may be implemented as at least part of, for example, a power management integrated circuit (PMIC).

The battery 189 may supply power to at least one component of the electronic device 101. According to an embodiment, the battery 189 may include, for example, a primary cell which is not rechargeable, a secondary cell which is rechargeable, or a fuel cell.

The communication module 190 may support establishing a direct (e.g., wired) communication channel or a wireless communication channel between the electronic device 101 and the external electronic device (e.g., the electronic device 102, the electronic device 104, or the server 108) and performing communication via the established communication channel. The communication module 190 may include one or more communication processors that are operable independently from the processor 120 (e.g., the application processor (AP)) and supports a direct (e.g., wired) communication or a wireless communication. According to an embodiment, the communication module 190 may include a wireless communication module 192 (e.g., a cellular communication module, a short-range wireless communication module, or a global navigation satellite system (GNSS) communication module) or a wired communication module 194 (e.g., a local area network (LAN) communication module or a power line communication (PLC) module). A corresponding one of these communication modules may communicate with the external electronic device via the first network 198 (e.g., a short-range communication network, such as Bluetooth^{™}, wireless-fidelity (Wi-Fi) direct, or infrared data association (IrDA)) or the second network 199 (e.g., a long-range communication network, such as a legacy cellular network, a 5G network, a next-generation communication network, the Internet, or a computer network (e.g., LAN or wide area network (WAN)). These various types of communication modules may be implemented as a single component (e.g., a single chip), or may be implemented as multi components (e.g., multi chips) separate from each other. The wireless communication module 192 may identify and authenticate the electronic device 101 in a communication network, such as the first network 198 or the second network 199, using subscriber information (e.g., international mobile subscriber identity (IMSI)) stored in the subscriber identification module 196.

The wireless communication module 192 may support a 5G network, after a 4G network, and next-generation communication technology, e.g., new radio (NR) access technology. The NR access technology may support enhanced mobile broadband (eMBB), massive machine type communications (mMTC), or ultra-reliable and low-latency communications (URLLC). The wireless communication module 192 may support a high-frequency band (e.g., the mmWave band) to achieve, e.g., a high data transmission rate. The wireless communication module 192 may support various technologies for securing performance on a high-frequency band, such as, e.g., beamforming, massive multiple-input and multiple-output (massive MIMO), full dimensional MIMO (FD-MIMO), array antenna, analog beam-forming, or large scale antenna. The wireless communication module 192 may support various requirements specified in the electronic device 101, an external electronic device (e.g., the electronic device 104), or a network system (e.g., the second network 199). According to an embodiment, the wireless communication module 192 may support a peak data rate (e.g., 20Gbps or more) for implementing eMBB, loss coverage (e.g., 164dB or less) for implementing mMTC, or U-plane latency (e.g., 0.5ms or less for each of downlink (DL) and uplink (UL), or a round trip of 1ms or less) for implementing URLLC.

The antenna module 197 may transmit or receive a signal or power to or from the outside (e.g., the external electronic device) of the electronic device 101. According to an embodiment, the antenna module 197 may include an antenna including a radiating element composed of a conductive material or a conductive pattern formed in or on a substrate (e.g., a printed circuit board (PCB)). According to an embodiment, the antenna module 197 may include a plurality of antennas (e.g., array antennas). In such a case, at least one antenna appropriate for a communication scheme used in the communication network, such as the first network 198 or the second network 199, may be selected, for example, by the communication module 190 (e.g., the wireless communication module 192) from the plurality of antennas. The signal or the power may then be transmitted or received between the communication module 190 and the external electronic device via the selected at least one antenna. According to an embodiment, another component (e.g., a radio frequency integrated circuit (RFIC)) other than the radiating element may be additionally formed as part of the antenna module 197.

According to various embodiments, the antenna module 197 may form a mmWave antenna module. According to an embodiment, the mmWave antenna module may include a printed circuit board, a RFIC disposed on a first surface (e.g., the bottom surface) of the printed circuit board, or adjacent to the first surface and capable of supporting a designated high-frequency band (e.g., the mmWave band), and a plurality of antennas (e.g., array antennas) disposed on a second surface (e.g., the top or a side surface) of the printed circuit board, or adj acent to the second surface and capable of transmitting or receiving signals of the designated high-frequency band.

At least some of the above-described components may be coupled mutually and communicate signals (e.g., commands or data) therebetween via an inter-peripheral communication scheme (e.g., a bus, general purpose input and output (GPIO), serial peripheral interface (SPI), or mobile industry processor interface (MIPI)).

According to an embodiment, commands or data may be transmitted or received between the electronic device 101 and the external electronic device 104 via the server 108 coupled with the second network 199. Each of the electronic devices 102 or 104 may be a device of a same type as, or a different type, from the electronic device 101. According to an embodiment, all or some of operations to be executed at the electronic device 101 may be executed at one or more of the external electronic devices 102, 104, or 108. For example, if the electronic device 101 should perform a function or a service automatically, or in response to a request from a user or another device, the electronic device 101, instead of, or in addition to, executing the function or the service, may request the one or more external electronic devices to perform at least part of the function or the service. The one or more external electronic devices receiving the request may perform the at least part of the function or the service requested, or an additional function or an additional service related to the request, and transfer an outcome of the performing to the electronic device 101. The electronic device 101 may provide the outcome, with or without further processing of the outcome, as at least part of a reply to the request. To that end, a cloud computing, distributed computing, mobile edge computing (MEC), or client-server computing technology may be used, for example. The electronic device 101 may provide ultra low-latency services using, e.g., distributed computing or mobile edge computing. In another embodiment, the external electronic device 104 may include an internet-of-things (IoT) device. The server 108 may be an intelligent server using machine learning and/or a neural network. According to an embodiment, the external electronic device 104 or the server 108 may be included in the second network 199. The electronic device 101 may be applied to intelligent services (e.g., smart home, smart city, smart car, or healthcare) based on 5G communication technology or IoT-related technology.

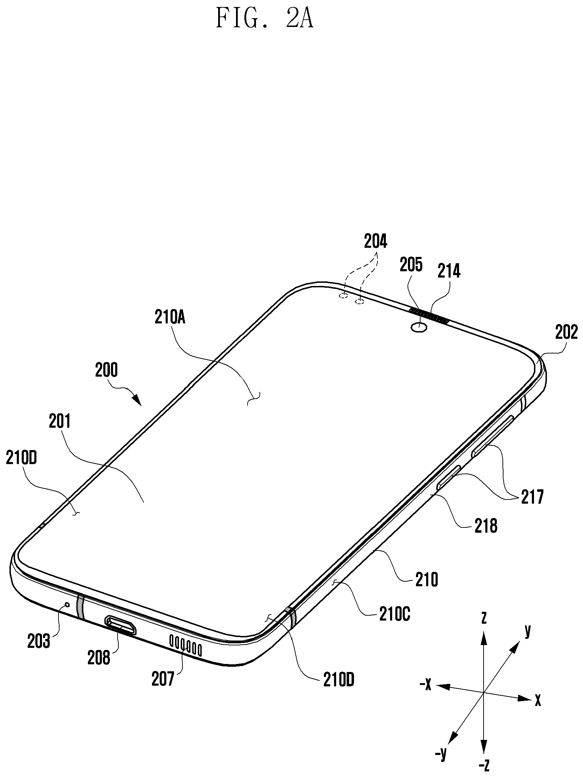

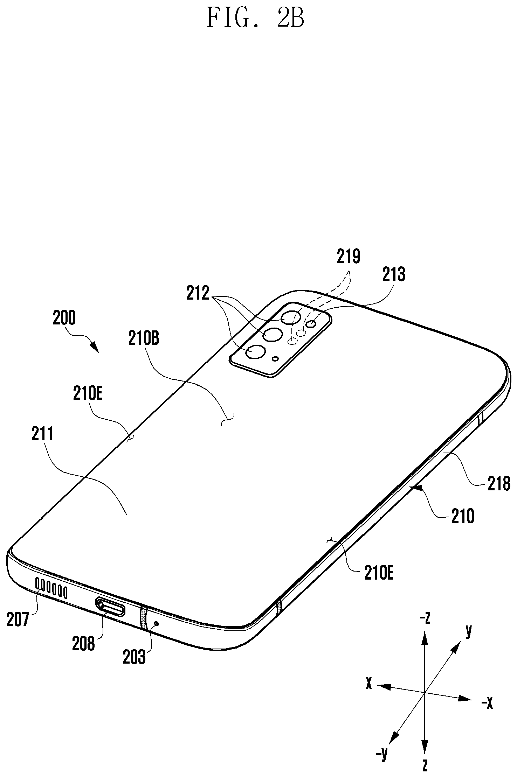

FIG. 2A illustrates a front perspective view of an electronic device according to various embodiments of the disclosure. FIG. 2B illustrates a rear perspective view of the electronic device of FIG. 2A according to various embodiments of the disclosure.

The electronic device 200 to be described below may include at least one of the components of the electronic device 101 described above with reference to FIG. 1.

With reference to FIG. 2A and FIG. 2B, the electronic device 200 according to an embodiment may include a housing 210 that includes a first surface (or front surface) 210A, a second surface (or rear surface) 210B, and a side surface 210C surrounding a space between the first surface 210A and the second surface 210B. According to an embodiment (not shown), the housing 210 may refer to a structure forming a part of the first surface 210A, the second surface 210B, and the side surface 210C in FIG. 2A. According to an embodiment, the first surface 210A may be formed by a front plate 202 (e.g., glass plate or polymer plate including various coating layers) whose at least a portion is substantially transparent. The second surface 210B may be formed by a rear plate 211 that is substantially opaque. The rear plate 211 may be formed by, for example, coated or tinted glass, ceramic, polymer, metal (e.g., aluminum, stainless steel (STS), or magnesium), or a combination of at least two thereof. The side surface 210C may be formed by a side bezel structure (or "side member") 218 coupled to the front plate 202 and the rear plate 211 and including a metal and/or a polymer. In a certain embodiment, the rear plate 211 and side bezel structure 218 may be integrally formed and include the same material (e.g., metal material such as aluminum).

In the illustrated embodiment, the front plate 202 may include a first region 210D that is curved and seamlessly extended from the first surface 210A toward the rear plate at opposite ends of each longer edge of the front plate 202. In the illustrated embodiment (see FIG. 2B), the rear plate 211 may include a second region 210E that is curved and seamlessly extended from the second surface 210B toward the front plate 202 respectively at opposite ends of each longer edge. In a certain embodiment, the front plate 202 or the rear plate 211 may include only one of the first region 210D and the second region 210E. In a certain embodiment, the front plate 202 may not include the first region and the second region, but may include only a flat surface disposed parallel to the second surface 210B. In the above embodiments, when the electronic device is viewed from the side thereof, the side bezel structure 218 may have a first thickness (or width) on a side where the first region 210D or the second region 210E is not included, and may have a second thickness thinner than the first thickness on a side where the first region 210D or the second region 210E is included.

According to an embodiment, the electronic device 200 may include at least one or more of display 201, input device 203, sound output devices 207 and 214, sensor modules 204 and 219, camera modules 205 and 212, key input device 217, indicator (not shown), or connector 208. In a certain embodiment, at least one of the elements (e.g., key input device 217 or indicator) may be omitted from the electronic device 200, or another element may be added to the electronic device 200.

The display 201 may be exposed, for example, through a significant portion of the front plate 202. In a certain embodiment, at least a portion of the display 201 may be exposed through the front plate 202 forming the first surface 210A and the first region 210D of the side surface 210C. The display 201 may be coupled to or disposed adjacent to a touch sensing circuit, a pressure sensor capable of measuring the intensity (pressure) of a touch, and/or a digitizer that detects a magnetic field type stylus pen. In a certain embodiment, at least some of the sensor modules 204 and 219, and/or at least some of the key input devices 217 may be disposed on the first region 210D and/or the second region 210E.

The input device 203 may include a microphone 203. In a certain embodiment, the input device 203 may include a plurality of microphones 203 arranged to detect the direction of a sound. The sound output devices 207 and 214 may include speakers 207 and 214. The speakers 207 and 214 may include an external speaker 207 and a call receiver 214. In a certain embodiment, the microphone 203, the speakers 207 and 214, and the connector 208 may be at least partially disposed in the internal space of the electronic device 200, and may be exposed to the external environment through at least one hole formed in the housing 210. In a certain embodiment, the hole formed in the housing 210 may be commonly used for the microphone 203 and the speakers 207 and 214. In a certain embodiment, the sound output devices 207 and 214 may include a speaker (e.g., piezo speaker) that operates in isolation from the hole formed in the housing 210.

The sensor modules 204 and 219 may generate an electrical signal or a data value corresponding to an internal operating state of the electronic device 200 or an external environmental state. The sensor modules 204 and 219 may include, for example, a first sensor module 204 (e.g., proximity sensor) and/or a second sensor module (not shown) (e.g., fingerprint sensor) disposed on the first surface 210A of the housing 210, and/or a third sensor module 219 (e.g., HRM(heart rate monitor) sensor) disposed on the second surface 210B of the housing 210. The fingerprint sensor may be disposed on the first surface 210A (e.g., home key button) of the housing 210, on a portion of the second surface 210B, and/or under the display 201. The electronic device 200 may further include a sensor module which is not shown, for example, at least one of a gesture sensor, a gyro sensor, a barometric pressure sensor, a magnetic sensor, an acceleration sensor, a grip sensor, a color sensor, an infrared (IR) sensor, a biometric sensor, a temperature sensor, a humidity sensor, a proximity sensor, or an illuminance sensor.

The camera modules 205 and 212 may include a first camera module 205 disposed on the first surface 210A of the electronic device 200, a second camera module 212 disposed on the second surface 210B, and/or a flash 213. The camera modules 205 and 212 may include one or plural lenses, an image sensor, and/or an image signal processor. The flash 213 may include, for example, a light emitting diode or a xenon lamp. In a certain embodiment, two or more lenses (wide-angle lens, ultra-wide-angle lens, or telephoto lens) and image sensors may be arranged in one surface of the electronic device 200.

The key input devices 217 may be arranged in the side surface 210C of the housing 210. According to an embodiment, the electronic device 200 may not include some or all of the above-mentioned key input devices 217, and a key input device 217 not included may be implemented on the display 201 in a different form such as a soft key. According to an embodiment, the key input devices 217 may be implemented using a pressure sensor included in the display 201.

The indicator may be disposed on, for example, the first surface 210A of the housing 210. The indicator may provide, for example, state information of the electronic device 200 in a light form (e.g., light emitting element). According to an embodiment, the light emitting element may provide a light source interacting with, for example, the operation of the camera module 205. The indicator may include, for example, an LED(light emitting diode), an IR(infrared) LED, and/or a xenon lamp.

The connector holes 208 may include a first connector hole 208 capable of accepting a connector (e.g., universal serial bus (USB) connector) for transmitting and receiving power and/or data to and from an external electronic device, and/or a second connector hole (e.g., earphone jack) (not shown) capable of accepting a connector for transmitting and receiving an audio signal to and from an external electronic device.

Some of the camera modules 205 and 212, some of the sensor modules 204 and 219, or the indicator may be disposed to be exposed through the display 201. For example, the camera module 205, the sensor module 204, or the indicator may be arranged in the internal space of the electronic device 200 so as to be in contact with the external environment through an opening of the display 201 perforated up to the front plate 202 or a transmissive region. According to an embodiment, the region in which the display 201 and the camera module 205 face each other may be formed as a transmissive region having a preset transmittance as a part of the content display area. According to an embodiment, the transmissive region may be formed to have a transmittance in a range of about 5 percent to about 20 percent. This transmissive region may include a region overlapping an effective area (e.g., angle-of-view area) of the camera module 205 through which light passes for image generation with an image formed by an image sensor. For example, the transmissive region of the display 201 may include a region having a lower pixel density than surrounding regions. For example, the transmissive region may replace the opening. For example, the camera module 205 may include an under display camera (UDC). According to an embodiment, a certain sensor module 204 may be disposed in the internal space of the electronic device so as to perform its function without being visually exposed through the front plate 202. For example, in this case, the region of the display 201 facing the sensor module may not need a perforated opening.

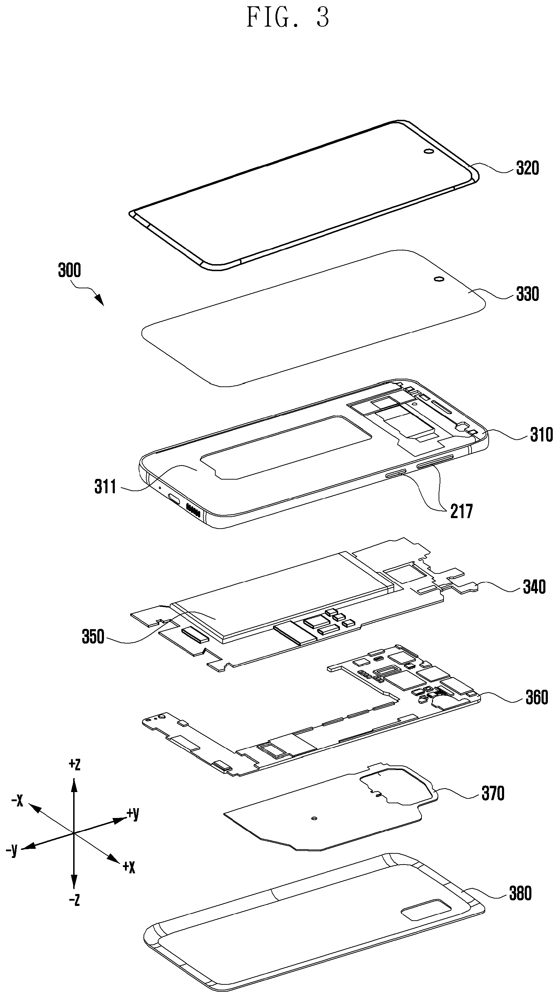

According to one embodiment, the electronic device 200 has a bar-type or plate-type appearance, but the present invention is not limited thereto. For example, the illustrated electronic device 200 may be part of a foldable electronic device, a slidable electronic device, a stretchable electronic device, and/or a rollable electronic device. The terms "foldable electronic device", "slidable electronic device", "stretchable electronic device" and/or "rollable electronic device" mean that the display (e.g., display 330 in FIG. 3) can be bent and deformed, so that at least part of it is folded or rolled, or an area of the display is at least partially expanded. It may refer to an electronic device that can be accommodated inside (e.g., the housing 210 of FIGS. 2A and 2B). Foldable electronic devices, slidable electronic devices, stretchable electronic devices, and/or rollable electronic devices expand the screen display area by unfolding the display or exposing a larger area of the display to the outside, depending on the user's needs.

FIG. 3 illustrates an exploded perspective view of the electronic device 200 of FIG. 2A according to various embodiments of the disclosure.

The electronic device 300 of FIG. 3 may be at least partially similar to the electronic device 200 of FIGS. 2A and 2B, or may include other embodiments of an electronic device.

With reference to FIG. 3, the electronic device 300 (e.g., electronic device 200 in FIGS. 2A or 2B) may include a side member 310 (e.g., side bezel structure), a first support member 311 (e.g., bracket or support structure), a front plate 320 (e.g., front cover)(e.g., front plate 202 in FIG. 2A), a display 330 (e.g., display 201 in FIG. 2A), a board 340 (e.g., printed circuit board (PCB), flexible PCB (FPCB), or rigid-flexible PCB (RFPCB)), a battery 350, a second support member 360 (e.g., rear case), an antenna 370, and a rear plate 380 (e.g., rear cover)( e.g., rear plate 211 in FIG. 2B). In a certain embodiment, at least one of the components (e.g., first support member 311 or second support member 360) may be omitted from the electronic device 300 or other components may be additionally included therein. At least one of the components of the electronic device 300 may be the same as or similar to at least one of the components of the electronic device 200 of FIGS. 2A or 2B, and repeated descriptions will be omitted below.

The first support member 311 may be disposed inside the electronic device 300 and may be connected to the side member 310 or may be integrally formed with the side member 310. The first support member 311 may be made of, for example, a metal material and/or a non-metal (e.g., polymer) material. The first support member 311 may have one surface coupled to the display 330 and the other surface coupled to the board 340. A processor (e.g., processor 120 in FIG. 1), a memory (e.g., memory 130 in FIG. 1), and/or an interface (e.g., interface 177 in FIG. 1) may be mounted on the board 340. The processor may include, for example, one or more of a central processing unit, an application processor, a graphics processing unit, an image signal processor, a sensor hub processor, and a communication processor.

The memory may include, for example, a volatile memory or a non-volatile memory.

The interface may include, for example, a high definition multimedia interface (HDMI), a universal serial bus (USB) interface, an SD (secure digital) card interface, and/or an audio interface. The interface may, for example, electrically or physically connect the electronic device 300 to an external electronic device, and may include a USB connector, an SD card/MMC (multimedia card) connector, or an audio connector.

The battery 350 is a device for supplying power to at least one component of the electronic device 300, and may include, for example, a non-rechargeable primary cell, a rechargeable secondary cell, or a fuel cell. At least a portion of the battery 350 may be disposed substantially coplanar with the board 340, for example. The battery 350 may be integrally disposed inside the electronic device 300. According to an embodiment, the battery 350 may be disposed attachably and detachably with the electronic device 300.

The antenna 370 may be disposed between the rear plate 380 and the battery 350. The antenna 370 may include, for example, a near field communication (NFC) antenna, a wireless charging antenna, and/or a magnetic secure transmission (MST) antenna. The antenna 370 may, for example, perform short-range communication with an external device or wirelessly transmit and receive power required for charging. According to an embodiment, an antenna structure may be formed by a part of the side bezel structure 310 and/or the first support member 311 or a combination thereof.

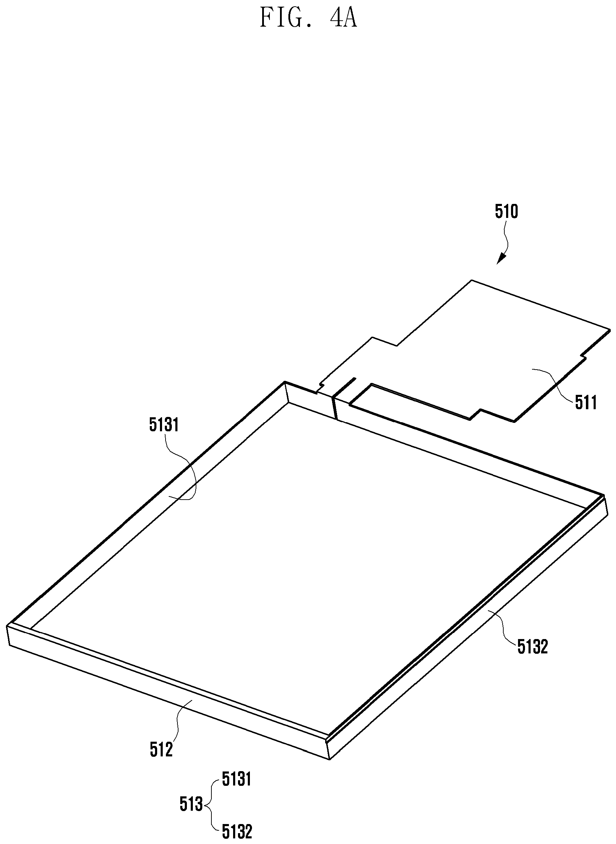

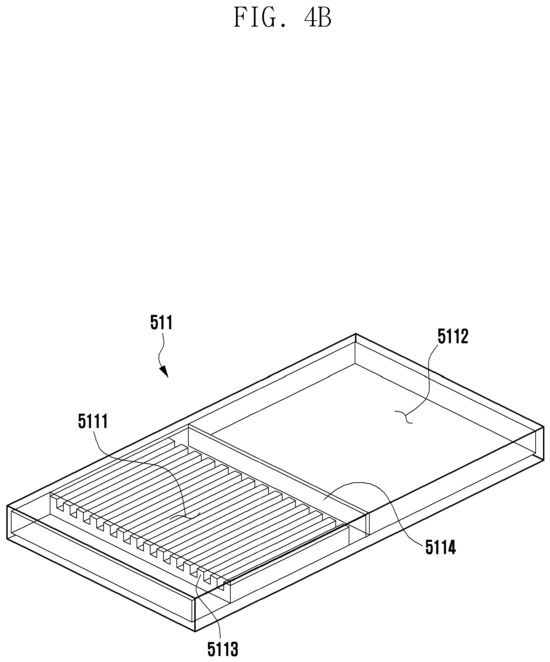

FIG. 4A illustrates a perspective view of a heat dissipation member disposed inside an electronic device according to an embodiment of the disclosure. FIG. 4B illustrates an enlarged view of a first heat exchanger of the heat dissipation member according to an embodiment of the disclosure.

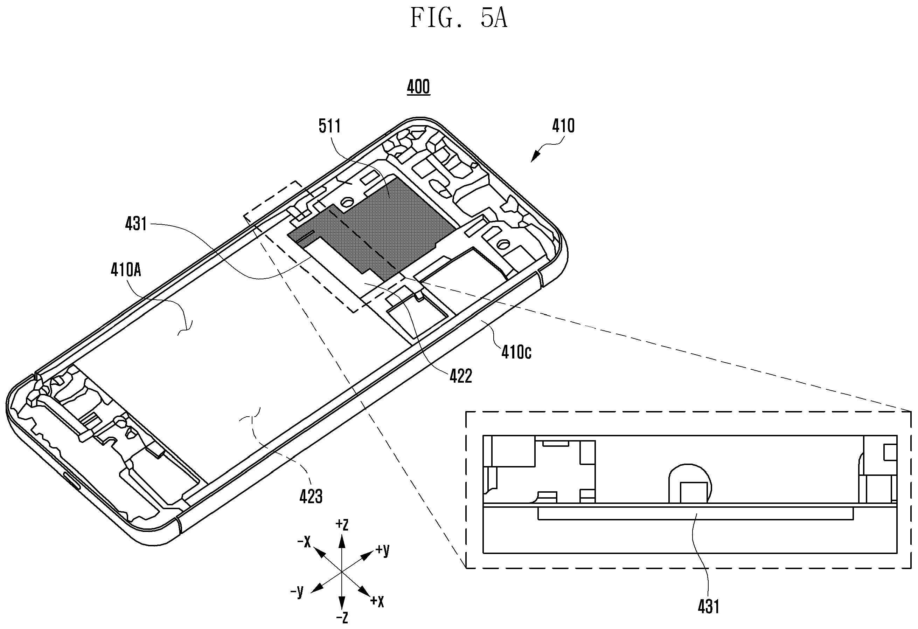

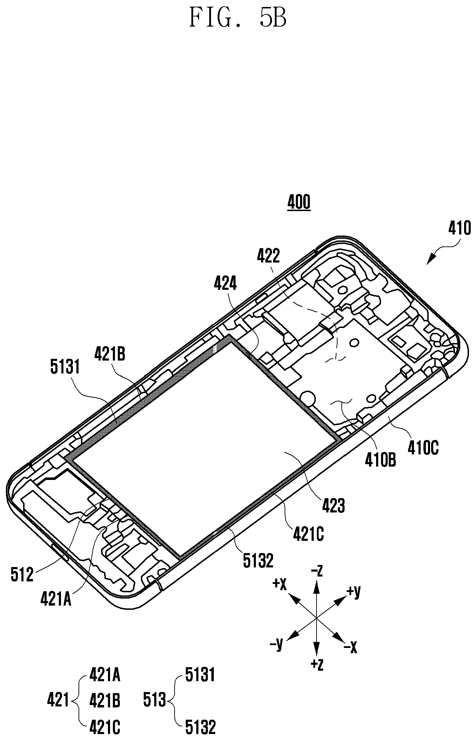

According to an embodiment, as illustrated in FIG. 4A, a heat dissipation member 510 may be disposed inside an electronic device 400 (e.g., the electronic device 101 of FIG. 1, the electronic device 200 in FIG. 2A, and/or the electronic device 300 in FIG. 3). In an embodiment, the heat dissipation member 510 may be a micro loop heat pipe (MLHP). For example, the heat dissipation member 510 may include a first heat exchanger 511 (e.g., an evaporator) configured to absorb heat from an external heat source and evaporate a working fluid, a second heat exchanger 512 (e.g., a condenser) configured to radiate heat to the outside to condense a gas into a fluid, and a conduit 513 interconnecting the first heat exchanger 511 and the second heat exchanger 512. In an embodiment, in the first heat exchanger 511, a liquid present in a heat dissipation member 510 comes into contact with a first electronic component placed in the electronic device 400 so that the liquid can be converted into vapor by heat transferred from the first electronic component. In the second heat exchanger 512, vapor generated in the first heat exchanger 511 can be phase-converted into liquid. In an embodiment, the conduit 513 may include a vapor pipe 5131 through which the gas generated in the first heat exchanger 511 is moved to the second heat exchanger 512, and a liquid pipe 5132 through which liquid generated in the second heat exchanger 512 is transferred to the first heat exchanger 511. In an embodiment, the vapor pipe 5131 and the liquid pipe 5132 may be arranged to be spaced apart from each other. The heat dissipation member 510 forms one loop inside the electronic device 400, and the working fluid is movable in one direction within the heat dissipation member 510. As will be described later, at least a portion of the heat dissipation member 510 is placed on the partition wall 424 and the inner wall 421 of the housing 410 of FIGS. 5A and 5B (e.g., the housing 210 in FIG. 2A) to form one loop.

According to an embodiment, the first heat exchanger 511 may include a contact portion 5111 which is in contact with an electronic component (e.g., the first electronic component disposed on the first seating portion 422 in FIGS. 5A and 5B), a compensation chamber 5112 to which the liquid generated in the second heat exchanger 512 is supplied, and a blocking portion 5114 which partitions the contact portion 5111 and the compensation chamber 5112. In an embodiment, referring to FIG. 4B, the contact portion 5111 may include a wick structure located therein. The wick structure 5113 may be a net-shaped mesh structure made of metal. In an embodiment, the wick structure 5113 may have a structure in which a plurality of heat dissipation fins are arranged in a row. In an embodiment, the wick structure 5113 may serve as a pump that moves the condensed heat medium from the compensation chamber 5112 to the contact portion 5111. In addition, like a mesh or a plurality of heat dissipation fins, the wick structure 5113 is able to increase heat transfer efficiency by maximizing the surface area. In an embodiment, the wick structure 5113 may be provided only in the first heat exchanger 511 of the heat dissipation member 510.

In an embodiment, the first heat exchanger 511 may include only the contact portion 5111. For example, the first heat exchanger 511 may not include the compensation chamber 5112 and the blocking portion 5114. In this case, the liquid transferred from the second heat exchanger 512 to the first heat exchanger 511 through the liquid pipe 5132 can be vaporized into gas in the first heat exchanger 511 and transferred to the second heat exchanger 512 through the vapor pipe 5131.

In an embodiment, the liquid generated in the second heat exchanger 512 may be supplied to the compensation chamber 5112 of the first heat exchanger 511. The liquid flowing into the compensation chamber 5112 passes through the wick structure 5113 and can be evaporated by heat generated in the first electronic component. The gas formed through the evaporation of the liquid can be transferred to the second heat exchanger 512 through the vapor pipe 5131. The gas delivered to the second heat exchanger 512 can be phase-converted into liquid and compensated for in the compensation chamber 5112 of the first heat exchanger 511. Accordingly, the fluid located inside the heat dissipation member 510 can be continuously circulated.

In an embodiment, the heat dissipation member 510 may be formed of a metal material. In an embodiment, the inside of the heat dissipation member 510 may be in a vacuum state. In an embodiment, the fluid located inside the heat dissipation member 510 may be filled in the heat dissipation member 510 to occupy about 60 to about 80% of the inner space of the heat dissipation member 510.

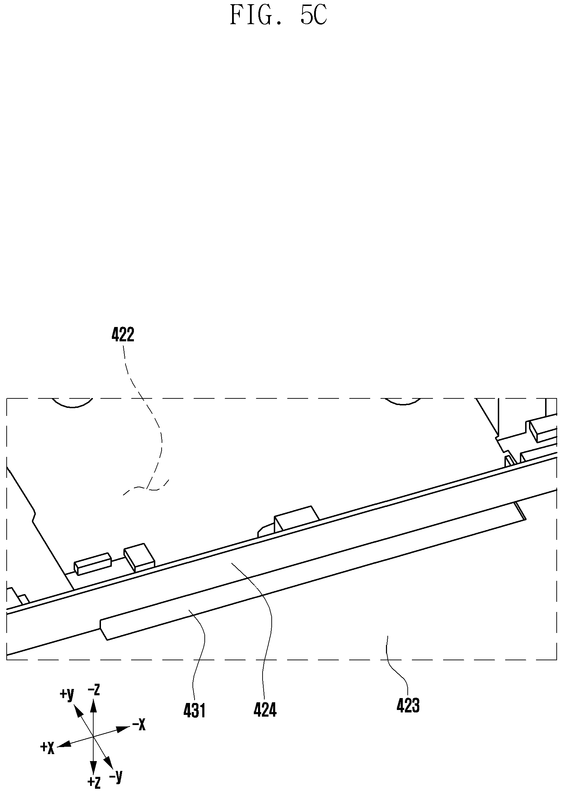

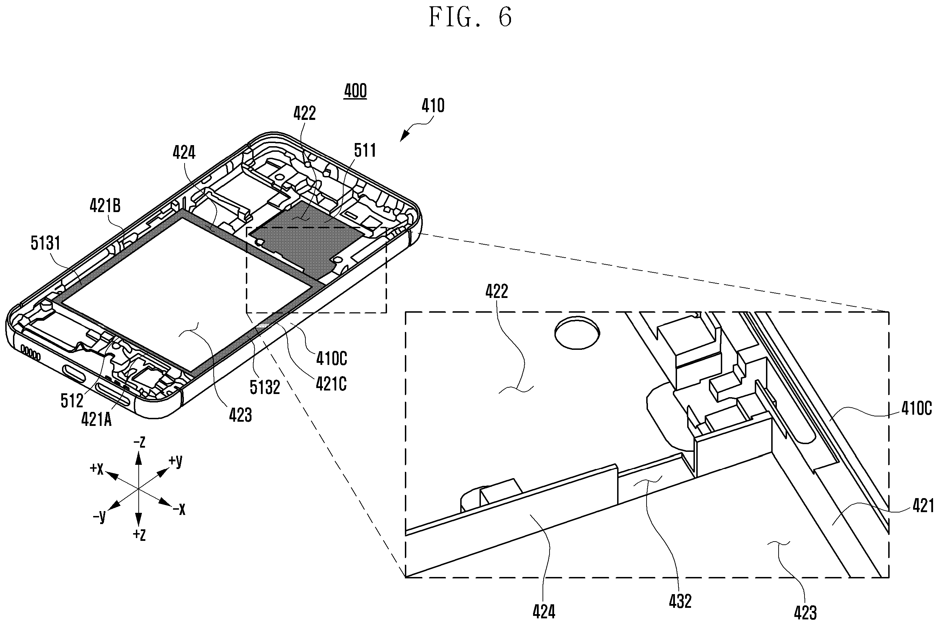

FIG. 5A is a view illustrating a state in which the first heat exchanger of the heat dissipation member according to an embodiment of the disclosure is arranged in the housing. FIG. 5B is a view illustrating a state in which the second heat exchanger, the vapor pipe, and the liquid pipe of the heat dissipation member of FIG. 5A are arranged. FIG. 5C illustrates an enlarged view of a first opening through which a portion of the heat dissipation member of FIGS. 5A and 5B passes. FIG. 6 illustrate a view of a state in which a heat dissipation member is disposed on one surface of a housing according to an embodiment of the disclosure, and an enlarged view of a second opening through which a portion of the heat dissipation member passes through a partition wall of the housing.

According to an embodiment of the disclosure, the housing 410 (e.g., the housing 210 in FIG. 2A) may be configured as follows. In an embodiment, the housing 410 may include a front surface 410A on which a display (e.g., the display module 160 in FIG. 1, the display 201 in FIG. 2A, or the display 330 in FIG. 3) is placed, a rear surface 410B opposite to the front surface 410A, and a side surface 410C surrounding the space between the front surface 410A and the rear surface 410B. In an embodiment, the housing 410 may include an inner wall 421 that protrudes toward the inner space. In an embodiment, the inner wall 421 may be a portion that protrudes from the side surface 410C of the housing 410 toward the inner space. In an embodiment, the housing 410 may include a first seating portion 422 on which at least one electronic component is placed, and a second seating portion 423 on which at least one other electronic component is placed. In an embodiment, the second seating portion 423 may be surrounded by the inner wall 421. In an embodiment, the housing 410 may include a partition wall 424 extending from the inner wall 421. In an embodiment, the partition wall 424 may partition the first seating portion 422 and the second seating portion 423.

In an embodiment, the inner wall 421 may include a first surface 421A facing the partition wall 424, a second surface 421B perpendicular to the first surface 421A and located between the partition wall 424 and the first surface 421A, and a third surface 421C facing the second surface 421B. In an embodiment, at least a portion of the heat dissipation member 510 may be disposed on the first surface 421A, the second surface 421B, and/or the third surface 421C of the inner wall 421.

In an embodiment, an electronic component of a high heat source, such as an application processor (AP), may be placed on the first seating portion 422. In an embodiment, the second seating portion 423 may be a battery seating portion. For example, the electronic component placed on the second seating portion 423 may be a battery. In addition, various electronic components may be placed on the first seating portion 422 and the second seating portion 423. Hereinafter, the electronic component disposed on the first seating portion 422 will be referred to as a first electronic component, and the electronic component disposed on the second seating portion 423 will be referred to as a second electronic component.

According to an embodiment, the first heat exchanger 511 of the heat dissipation member 510 may be in contact with the first electronic component placed on the first seating portion 422. The second heat exchanger 512 may be placed on the inner wall 421 in the second seating portion 423. In an embodiment, the first heat exchanger 511, which phase-converts liquid into gas, and the second heat exchanger 512, which phase-converts gas into liquid, are spaced apart to efficiently perform heat exchange for phase conversion. For example, the second heat exchanger 512 may be placed on the first surface 421A of the inner wall 421 facing the partition wall 424. In an embodiment, the vapor pipe 5131 may be at least partially placed on the second surface 421B of the inner wall 421and the partition wall 424 so that the vapor generated in the first heat exchanger 511 can be supplied to the second heat exchanger 512. In an embodiment, at least a portion of the liquid pipe 5132 may be placed on the third surface 421C of the inner wall 421 and the partition wall 424 so that the liquid generated in the second heat exchanger 512 can be supplied to the first heat exchanger 511. In an embodiment, the second heat exchanger 512, the vapor pipe 5131, and the liquid pipe 5132 may be located on the second seating portion 423 to face the second electronic component. In an embodiment, the second heat exchanger 512, the vapor pipe 5131, and the liquid pipe 5132 may be in contact with the second electronic component or may be attached to the second electronic component via an adhesive member.

According to an embodiment, one of the first seating portion 422 and the second seating portion 423 may be disposed to face the front surface 410A of the electronic device 400, and the other one may be provided in the housing 410 to face the rear surface 410B of the electronic device 400. In an embodiment, referring to FIG. 5A, the first seating portion 422 may be provided in the housing 410 to face the front surface 410A of the electronic device 400. Referring to FIG. 5B, the second seating portion 423 may be disposed to face the rear surface 410B of the electronic device 400. The inner wall 421 may surround the second seating portion 423 on the rear surface 410B of the electronic device 400. In an embodiment, referring to FIGS. 5A and 5B, the first heat exchanger 511 of the heat dissipation member 510 may be located on the first seating portion 422. The second heat exchanger 512 may be placed on the first surface 421A of the inner wall 421 located on the second seating portion 423. The vapor pipe 5131 may be disposed on the second surface 421B of the inner wall 421 and the partition wall 424. The liquid pipe 5132 may be placed on the third surface 421C of the inner wall 421 and the partition wall 424. In an embodiment, referring to FIG. 5C, the housing 410 may include a first opening 431 interconnecting the front surface 410A of the housing 410 and the rear surface 410B of the housing 410 such that the first heat exchanger 511 located on the first seating portion 422 and the second heat exchanger 512 located on the second seating portion 423 can be connected to each other. In an embodiment, the vapor pipe 5131 of the heat dissipation member 510 may extend from the first heat exchanger 511 to pass through the first opening 431, and may be partially placed on the partition wall 424 and the second surface 421B of the inner wall 421 to be connected to the second heat exchanger 512 located on the first surface 421A of the inner wall 421. In an embodiment, the liquid pipe 5132 may extend from the second heat exchanger 512 to be partially placed on the third surface 421C of the inner wall 421 and the partition wall 424 and may pass through the first opening 431 to be connected to the first heat exchanger 511.

In the above description, the description has been made on the assumption that the first seating portion 422 is provided to face the front surface 410A of the electronic device 400 and the second seating portion 423 is provided to face the rear surface 410B of the electronic device 400, but the disclosure may not be limited thereto. Even when the first seating portion 422 is provided to face the rear surface 410B of the electronic device 400 and the second seating portion 423 is provided to face the front surface 410A of the electronic device 400, the above description can be applied equally.

According to an embodiment, the first seating portion 422 and the second seating portion 423 may be provided in the housing 410 to face the front surface 410A or the rear surface 410B of the electronic device 400. In an embodiment, referring to FIG. 6, the first seating portion 422 and the second seating portion 423 may be provided in the housing 410 to face the rear surface 410B of the electronic device 400. In an embodiment not illustrated in the drawings, the first seating portion 422 and the second seating portion 423 may be provided in the housing 410 to face the front surface 410A of the electronic device 400.

According to an embodiment, as illustrated in FIG. 6, the first heat exchanger 511 of the heat dissipation member 510 may be located on the first seating portion 422. The second heat exchanger 512 may be placed on the first surface 421A of the inner wall 421 located on the second seating portion 423. The vapor pipe 5131 may be at least partially disposed on the second surface 421B of the inner wall 421 and the partition wall 424. The liquid pipe 5132 may be at least partially placed on the third surface 421C of the inner wall 421 and the partition wall 424. In an embodiment, referring to FIG. 6, the partition wall 424 may include a second opening 432 through which a portion of the heat dissipation member 510 passes. In an embodiment, referring to FIG. 5, the vapor pipe 5131 of the heat dissipation member 510 may extend from the first heat exchanger 511 to pass through the second opening 432, and may be partially placed on the partition wall 424 and the second surface 421B of the inner wall 421 to be connected to the second heat exchanger 512 located on the first surface 421A of the inner wall 421. In an embodiment, the liquid pipe 5132 may extend from the second heat exchanger 512 to be partially placed on the third surface 421C of the inner wall 421 and the partition wall 424 and may pass through the second opening 432 to be connected to the first heat exchanger 511.

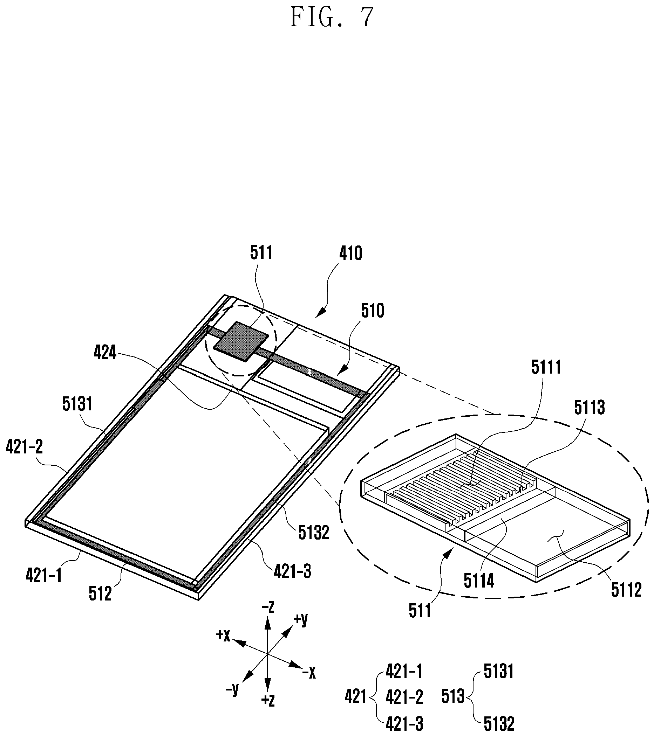

FIG. 7 is a view illustrating a state in which a portion of a heat dissipation member is disposed inside the inner wall of a housing according to an embodiment of the disclosure.

According to an embodiment, as illustrated in FIG. 7, at least a portion of the heat dissipation member 510 may be located inside the inner wall 421 of the housing 410 (e.g., the housing 210 in FIG. 2A). In an embodiment, the inner wall 421 may include a (1-1)^{th} inner wall 421-1 facing the partition wall 424, a (1-2)ₜₕ inner wall 421-2 located between the partition wall 424 and the (1-1)ₜₕ inner wall 421-1 to be perpendicular to the (1-1)ₜₕ inner wall 421-1, and a (1-3)ₜₕ inner wall 421-3 facing the (1-2)ₜₕ inner wall 421-2. In an embodiment, the first surface 421A of the inner wall 421 described above may be one surface of the first inner wall 421-1, the second surface 421B of the inner wall 421 may be one surface of the (1-2)^{th} inner wall 421-2, and the third surface 421C of the inner wall 421 may be one surface of the (1-3)^{th} inner wall 421-3. In an embodiment, the (1-1)^{th} inner wall 421-1, the (1-2)^{th} inner wall 421-2, and the (1-3)^{th} inner wall 421-3 may include inner spaces in which at least a portion of the heat dissipation member 510 can be placed. In an embodiment, the inner spaces provided in the (1-1)^{th} inner wall 421-1, the (1-2)^{th} inner wall 421-2, and the (1-3)^{th} inner wall 421-3 may be connected to each other. In an embodiment, the second heat exchanger 512 may be located inside the (1-1)^{th} inner wall 421-1. The vapor pipe 5131 may be at least partially located inside the (1-2)^{th} inner wall 421-2 to interconnect the first heat exchanger 511 located on the first seating portion 422 and the second heat exchanger 512 located inside the (1-1)^{th} inner wall 421-1. At least a portion of the liquid pipe 5132 may be located inside the (1-3)^{th} inner wall 421-3 to interconnect the first heat exchanger 511 and the second heat exchanger 512.

As described above, when a portion of the heat dissipation member 510 is located inside the inner wall 421, the area occupied by the heat dissipation member 510 inside the electronic device 400 may increase in comparison to the case where at least a portion of the heat dissipation member 510 is disposed on the outer surface (e.g., the first surface 421A, the second surface 421B, and the third surface) of the inner wall 421 and the partition wall 424. For example, the area occupied by the heat dissipation member 510 may increase in the X-axis direction and/or the Y-axis direction with reference to FIG. 7. In this case, the area where heat generated from the first electronic component is diffused increases so that the heat dissipation efficiency of the electronic device 400 can be improved.

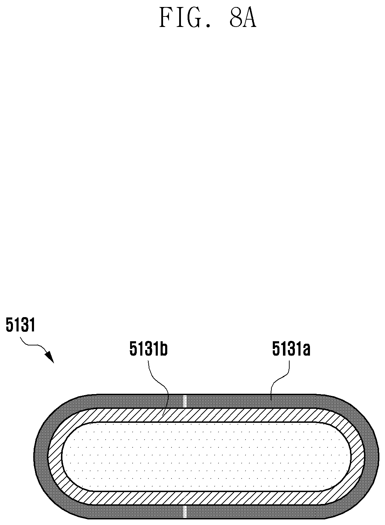

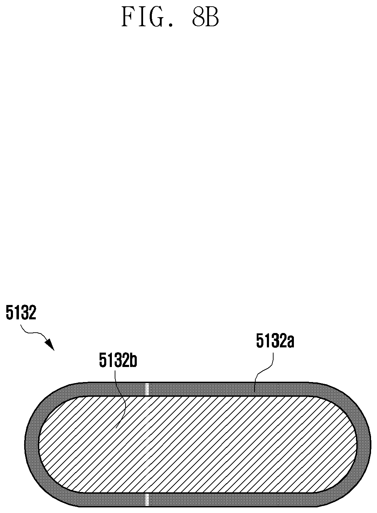

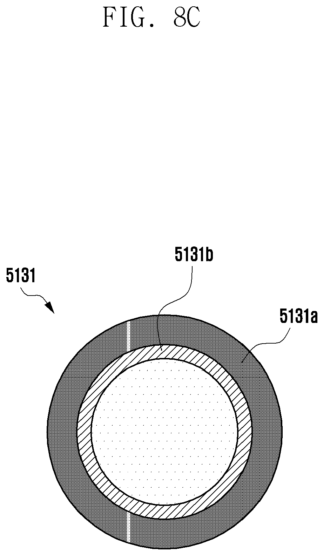

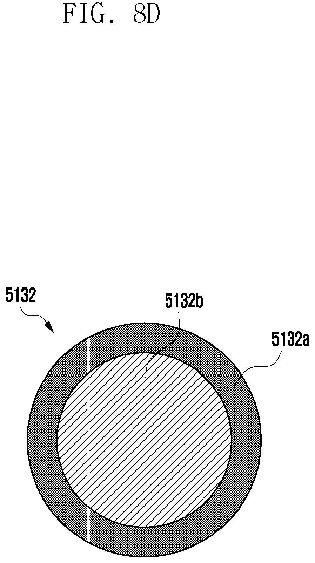

FIG. 8A illustrates a cross-sectional view of a vapor pipe of a heat dissipation member according to an embodiment of the disclosure. FIG. 8B illustrates a cross-sectional view of a liquid pipe of a heat dissipation member according to an embodiment of the disclosure. FIG. 8C illustrates a cross-sectional view of a vapor pipe of a heat dissipation member according to an embodiment of the disclosure. FIG. 8D illustrates a cross-sectional view of a liquid pipe of a heat dissipation member according to an embodiment of the disclosure.

According to an embodiment, the heat dissipation member 510 may be configured in various shapes. In an embodiment, as illustrated in FIGS. 5A, 5B, and 6, at least one surface of the heat dissipation member 510 may be flat so that the first heat exchanger 511 can be placed on the first seating portion 422, the second heat exchanger 512 can be disposed on the first surface 421A of the inner wall 421, the vapor pipe 5131 can be placed on the partition wall 424 and the second surface 421B of the inner wall 421, and the liquid pipe 5132 can be placed on the third surface 421C of the inner wall 421 and the partition wall 424. In an embodiment, referring to FIGS. 8A and 8B, the vapor pipe 5131 and the liquid pipe 5132 may be configured to be flat in at least two surfaces to be in close contact with the partition wall 424 and to reduce the volume occupied on the seating portion 423. In an embodiment, referring to FIGS. 8C and 8D, the vapor pipe 5131 and the liquid pipe 5132 may be provided in a circular pipe shape. In an embodiment, referring to FIGS. 7, 8C, and 8D, the vapor pipe 5131 may be configured in a circular cross-sectional shape and placed inside the (1-2)^{th} inner wall 421-2, and the liquid pipe 5132 may be configured in a circular cross-sectional shape and placed inside the third inner wall 421-3.

According to an embodiment, the outer surface of the heat dissipation member 510 may be made of a metal material. For example, the outer surface of the heat dissipation member 510 may be made of materials such as copper, gold, silver, and/or aluminum. In an embodiment, referring to FIGS. 8A to 8D, the outer surface 5131a of the vapor pipe 5131 and the outer surface 5132a of the liquid pipe 5132 may be made of a metal material.

According to an embodiment, the conduit 513 (e.g., the vapor pipe 5131 and the liquid pipe 5132) may include a mesh structure placed therein. In an embodiment, referring to FIGS. 8A and 8C, the vapor pipe 5131 may include a wick structure 5131b located therein. The wick structure 5131b may be a net-shaped mesh structure made of metal. In an embodiment, the vapor pipe 5131 may move vapor to the second heat exchanger 512 through capillary action by the wick structure 5131b. In an embodiment, referring to FIGS. 8B and 8D, the vapor pipe 5132 may include a wick structure 5132b located therein. In an embodiment, the liquid pipe 5132 may move liquid to the first heat exchanger 511 through capillary action by the wick structure 5132b.

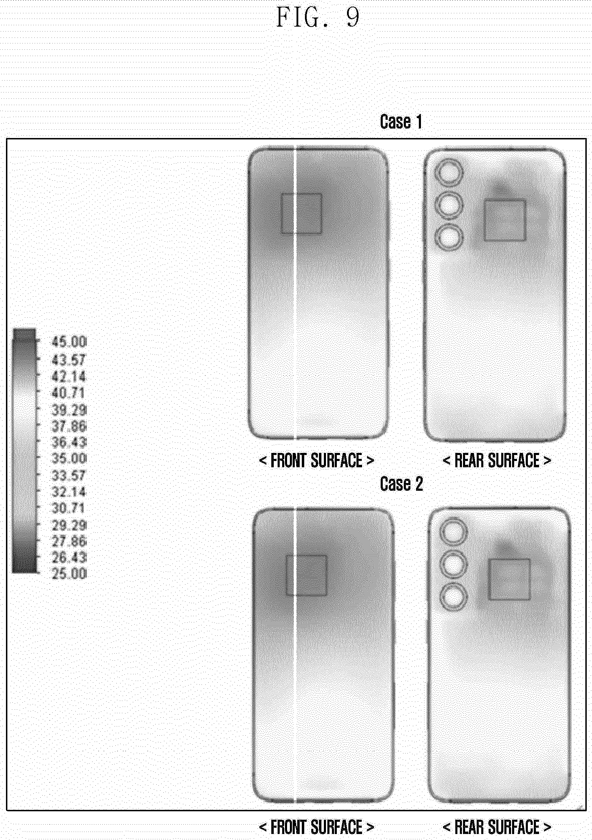

FIG. 9 is a view illustrating the heat dissipation performance of the heat dissipation member 510 according to an embodiment of the disclosure.

According to an embodiment of the disclosure, the heat dissipation performance of the heat dissipation member 510 may be identified with reference to FIG. 9 and Table 1.

**[Table 1]**

| T [°C] | Case 1 | Case 2 |
|---|---|---|
| Front surface | 43.3 | 43.3 |
| Rear surface | 42.4 | 42.3 |
| First electronic component | 68.2 | 67.6 |

In an embodiment, referring to Table 1 above, as illustrated in FIGS. 5A and 5B, when the first heat exchanger 511 of the heat dissipation member 510 is located on the front surface 410A of the electronic device 400 and the remaining components, i.e., the second heat exchanger 512, the vapor pipe 5131, and the liquid pipe 5132, are located on the rear surface 410B of the electronic device 400 (e.g., Case 1 in Table 1), it can be seen that the temperature of the front surface 410A of the electronic device 400 is about 43.3 degrees C, the temperature of the rear surface 410B of the electronic device 400 is about 42.4 degrees C, and the temperature of the first electronic component is about 68.2 degrees C. In addition, in an embodiment, referring to [Table 1] above, as illustrated in FIG. 6, when the first heat exchanger 511, the second heat exchanger 512, the vapor pipe 5131, and the liquid pipe 5132 of the heat dissipation member 510 are placed in the housing 410 (e.g., the housing 210 in FIG. 2A) to face the rear surface 410B of the electronic device 400 (e.g., Case 2 in Table 1), it can be seen that the temperature of the front side surface 410A of the electronic device 400 is about 43.3 degrees C, the temperature of the rear surface 410B of the electronic device 400 is about 42.3 degrees C, and the temperature of the first electronic component is about 67.6 degrees C. In an embodiment, referring to FIG. 9, it can be seen that the temperature distribution is efficiently distributed over the entire area of the electronic device 400 in the structure to which the heat dissipation member 510 of the disclosure is applied. In an embodiment, referring to FIG 9, when the first heat exchanger 511, the second heat exchanger 512, the vapor pipe 5131, and the liquid pipe 5132 of the heat dissipation member 510 are placed in the housing 410 to face the rear surface 410B of the electronic device 400 (e.g., Case 2 in Table 1), as illustrated in FIG. 6, and when the first heat exchanger 511 of the heat dissipation member 510 is located on the front surface 410A of the electronic device 400, and the remaining components, i.e., the second heat exchanger 512, the vapor pipe 5131, and the liquid pipe 5132, are located on the rear surface 410B of the electronic device 400 (e.g., Case 1 in Table 1), as illustrated in FIGS. 5A and 5B, it can be seen that the temperatures of the front surface 410A, the rear surface 410B, and the first electronic component of the electronic device 400 are similar.

According to an embodiment of the disclosure, it is possible to increase the heat diffusion area within the electronic device 400 with the heat dissipation member 510 to which the micro loop heat pipe structure is applied. In addition, as no separate processing is performed in the thickness direction of the housing 410 in order to dispose the heat dissipation member 510 since at least a portion of the heat dissipation member 510 (e.g., the second heat exchanger 512, the vapor pipe 5131, and the liquid pipe 5132) is placed along the inner wall 421 and/or the partition wall 424 of the housing 410, the rigidity of the housing 410 can be ensured at a predetermined level.

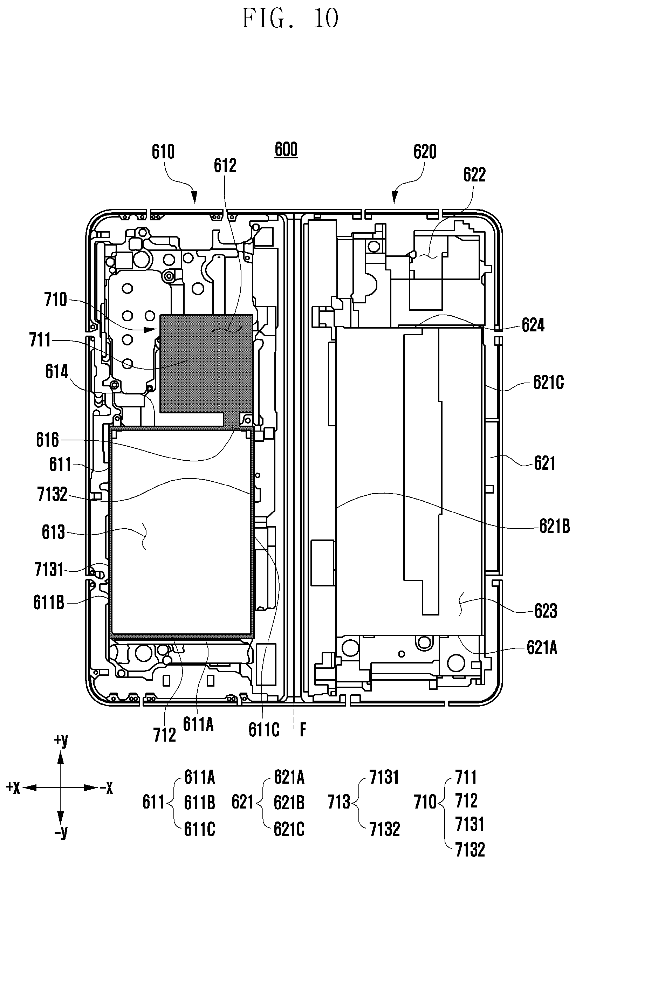

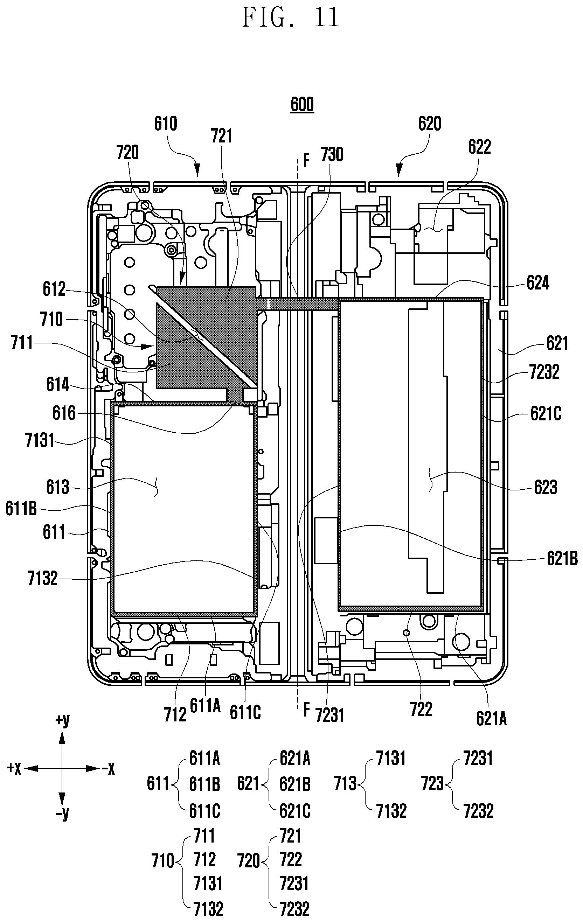

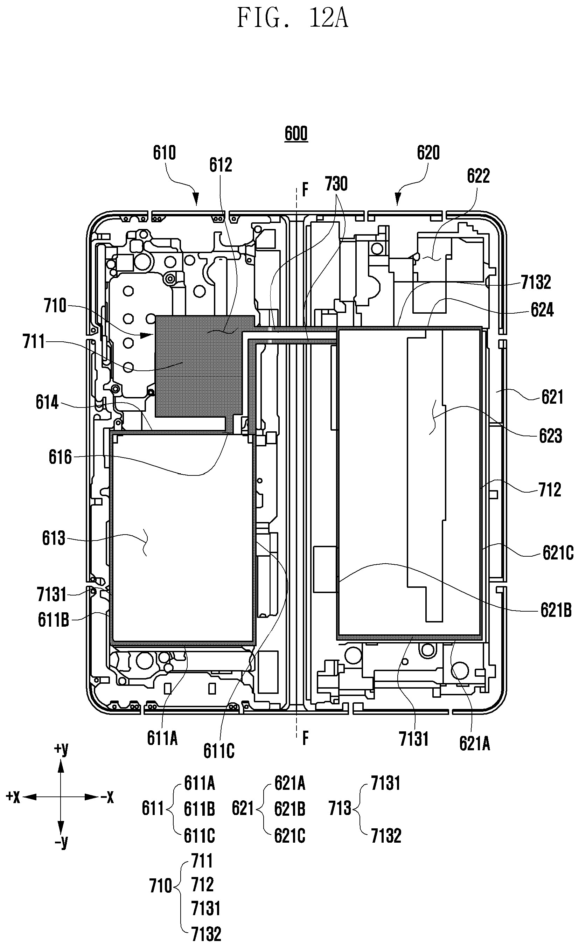

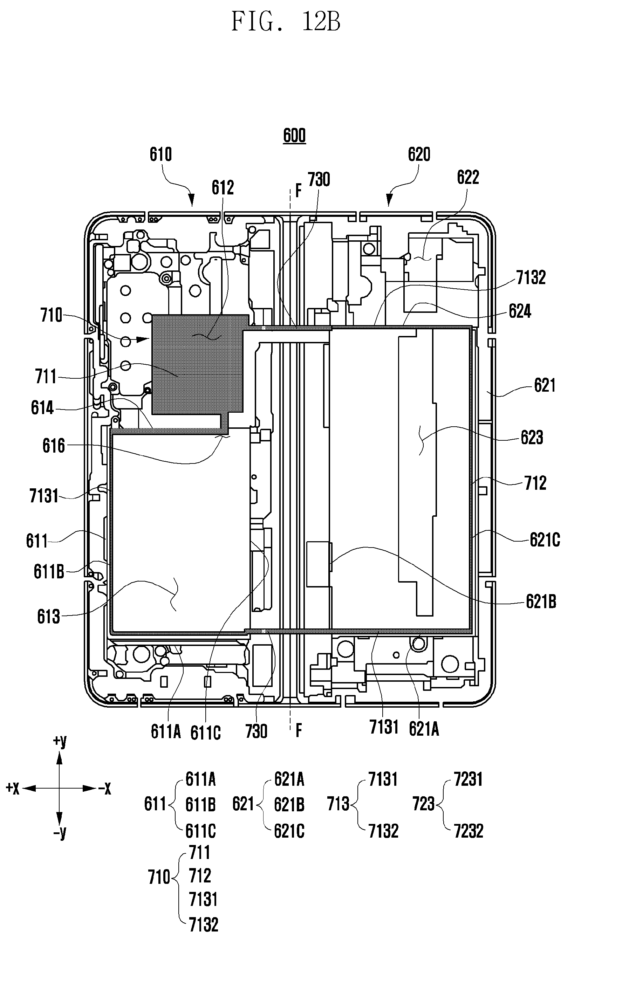

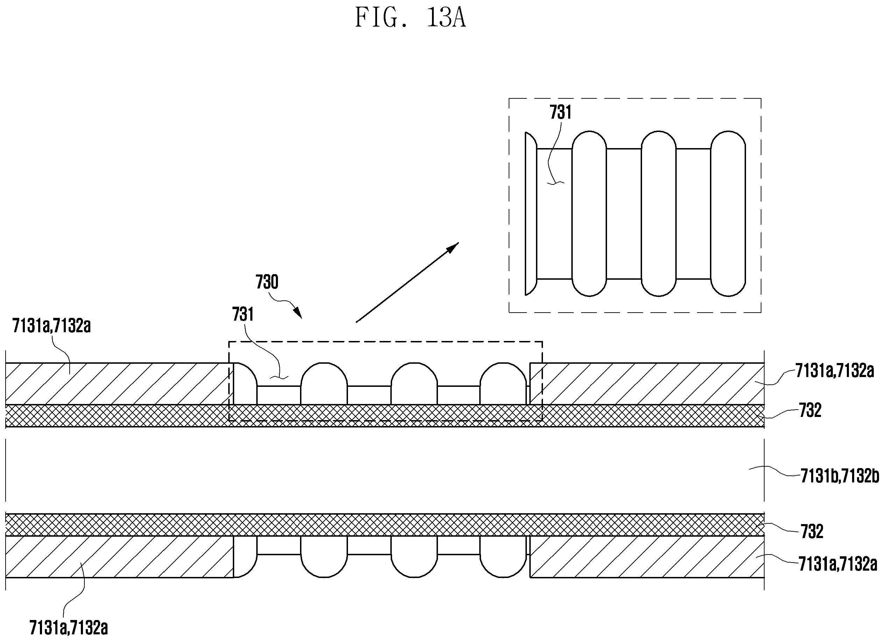

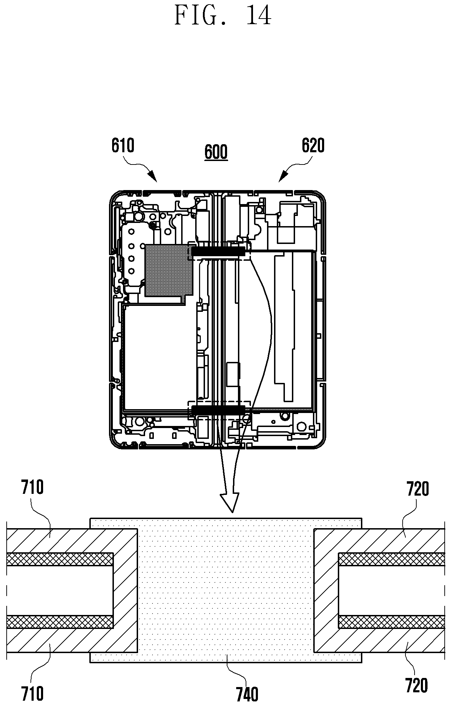

FIG. 10 is a view illustrating a state in which a heat dissipation member is disposed in a first housing according to an embodiment of the disclosure. FIG. 11 is a view illustrating a state in which a portion of the first heat dissipation member placed in the first housing and a portion of the second heat dissipation member, which is at least partially placed in the second housing, are in contact with electronic components arranged in the first housing 610 according to an embodiment of the disclosure. FIGS. 12A and 12B are views illustrating a state in which the first heat dissipation member placed in the first housing and the second heat dissipation member placed in the second housing are connected to each other via a connection portion located in the folding area. FIGS. 13A to 13C are views illustrating various embodiments of the connection portion according to an embodiment of the disclosure. FIG. 14 is a view illustrating a state in which the first heat dissipation member placed in the first housing and the second heat dissipation member placed in the second housing are connected to each other via a third connection portion located in the folding area.

The electronic device 600 to be described below may be a foldable electronic device 600 having a different form factor from the electronic device 200, 300, or 400 illustrated in FIGS. 3 to 8D, and including a plurality of housings coupled to each other via a hinge device to be foldable about a folding axis. In the following description, the same reference numerals are used for components that are the same as or similar to those described above with reference to FIGS. 3 to 8D, and detailed descriptions thereof will be omitted.

According to an embodiment, the electronic device 600 may include a pair of housings 610 and 620 that are rotatably coupled by at least one hinge device (not illustrated) to be foldable relative to each other about a folding axis F. In an embodiment, the electronic device 600 may include a display (e.g., the display module 160 in FIG. 1, the display 201 in FIG. 2A, or the display 330 in FIG. 3) placed on the pair of housings 610 and 620. In an embodiment, the display can be folded or unfolded together with the electronic device 600 about the folding axis.

According to an embodiment, the pair of housings 610 and 620 may include a first housing 610 and a second housing 620 that are foldable relative to each other via at least one hinge device. In an embodiment, the first housing 610 and the second housing 620 may be disposed on opposite sides of a folding axis F, may have shapes that are generally symmetrical to each other with respect to the folding axis F, and may be folded to match each other. According to some embodiments, the first housing 610 and the second housing 620 may be folded asymmetrically with respect to the folding axis F. According to an embodiment, the first housing 610 and the second housing 620 may form an angle or a distance therebetween, which may be variable depending on whether the electronic device 600 is in the unfolded state, in the folded state, or in the intermediate state.

According to an embodiment, the first housing 610 and the second housing 620 may be configured as follows. In an embodiment, the first housing 610 and the second housing 620 may each include a front surface on which a display is placed, a rear surface opposite to the front surface, and a side surface surrounding the space between the front and rear surfaces. In an embodiment, the first housing 610 may include a first inner wall 611 that protrudes toward the inner space. In an embodiment, the first housing 610 may include a first seating portion 612 on which at least one electronic component (e.g., a first electronic component) is placed and a second seating portion 613 on which at least one other electronic component (e.g., a second electronic component) is placed. In an embodiment, the second seating portion 613 may be surrounded by the first inner wall 611. In an embodiment, the first housing 610 may include a first partition wall 614 extending from the first inner wall 611. In an embodiment, the first partition wall 614 may partition the first seating portion 612 and the second seating portion 613. In an embodiment, the second housing 620 may include a second inner wall 621 that protrudes toward the inner space. In an embodiment, the second housing 620 may include a third seating portion 622 on which at least one electronic component (e.g., a third electronic component) is placed and a fourth seating portion 623 on which at least one other electronic component (e.g., a fourth electronic component) is placed. In an embodiment, the third seating portion 622 may be surrounded by the second inner wall 621. In an embodiment, the second housing 620 may include a second partition wall 624 extending from the second inner wall 621. In an embodiment, the second partition wall 624 may partition the third seating portion 622 and the fourth seating portion 623.

The above-described first to fourth electronic components may be various types of electronic components. For example, the first to fourth electronic components may be various types of electronic components such as a battery, an AP, and a printed circuit board.

In an embodiment, the first inner wall 611 of the first housing 610 may include a first surface 611A facing the first partition wall 614, a second surface 611B perpendicular to the first surface 611A and located between the first partition wall 614 and the first surface 611A, and a third surface 611C facing the second surface 611B. In an embodiment, at least a portion of the first heat dissipation member 710 may be placed on the first surface 611A, the second surface 611B, and/or the third surface 611C of the first inner wall 611. In an embodiment, the second inner wall 621 of the second housing 620 may include a first surface 621A facing the second partition wall 624, a second surface 621B perpendicular to the first surface 621A and located between the second partition wall 624 and the first surface 621A, and a third surface 621C facing the second surface 621B. In an embodiment, at least a portion of the second heat dissipation member 720 may be placed on the first surface 621A, the second surface 621B, and/or the third surface 621C of the second inner wall 621.

In an embodiment, the first heat dissipation member 710 and the second heat dissipation member 720 may be made of a metal material with high heat conduction efficiency. For example, the first heat dissipation member 710 and the second heat dissipation member 720 may be made of materials such as copper, gold, silver, and/or aluminum.

According to an embodiment, as illustrated in FIG. 10, the electronic device 600 may include the first heat dissipation member 710 placed in the first housing 610. In an embodiment, the first heat dissipation member 710 may have substantially the same configuration as the heat dissipation member of FIG. 4A described above. For example, the first heat dissipation member 710 may include a first heat exchanger 711 (e.g., the first heat exchanger 511 in FIG. 4A), a second heat exchanger 712 (e.g., the second heat exchanger 512 in FIG. 4A), and a first conduit 713 (e.g., the first vapor pipe 7131 (e.g., the vapor pipe 5131 in FIG. 4A) and the first liquid pipe 7132 (e.g., the liquid pipe 5132 in FIG. 4A)). In an embodiment, referring to FIG. 10, the first heat exchanger 711 of the first heat dissipation member 710 may be located on the first seating portion 612 to be in contact with the first electronic component. The second heat exchanger 712 may be placed on the first surface 611A of the first inner wall 611 located on the second seating portion 613. The first vapor pipe 7131 may be placed on the second surface 611B of the first inner wall 611 and the first partition wall 614. The first liquid pipe 7132 may be placed on the third surface 611C of the first inner wall 611 and the first partition wall 614. In an embodiment, the second heat exchanger 712, the first vapor pipe 7131, and the first liquid pipe 7132 may face the second electronic component. In an embodiment, the second heat exchanger 712, the first vapor pipe 7131, and the first liquid pipe 7132 may be in contact with the second electronic component or may be attached to the second electronic component via an adhesive member.

In an embodiment, the first partition wall 614 may include a first opening 616 through which a portion of the first heat dissipation member 710 passes. In an embodiment, referring to FIG. 6, the first vapor pipe 7131 of the first heat dissipation member 710 may extend from the first heat exchanger 711 to pass through the first opening 616, and may be partially placed on the first partition wall 614 and the second surface 611B of the first inner wall 611 to be connected to the second heat exchanger 712 located on the first surface 611A of the first inner wall 611. In an embodiment, the first liquid pipe 7132 may extend from the second heat exchanger 712 to be partially placed on the third surface 611C of the first inner wall 611 and the first partition wall 614 and may pass through the first opening 616 to be connected to the first heat exchanger 711.

According to an embodiment, as illustrated in FIG. 11, the electronic device 600 may include the second heat dissipation member 720 placed in the second housing 620. In an embodiment, the second heat dissipation member 720 may have substantially the same configuration as the heat dissipation member of FIG. 4A described above. For example, the second heat dissipation member 720 may include a third heat exchanger 721 (e.g., the first heat exchanger 511 in FIG. 4A), a fourth heat exchanger 722 (e.g., the second heat exchanger 512 in FIG. 4A), and a second conduit 723 (e.g., the second vapor pipe 7231 (e.g., the vapor pipe 5131 in FIG. 4A) and the second liquid pipe 7232 (e.g., the liquid pipe 5132 in FIG. 4A)). In an embodiment, referring to FIG. 11, the third heat exchanger 721 of the second heat dissipation member 720 may be located on the first seating portion 612 to be in contact with the first electronic component. In an embodiment, the fourth heat exchanger 722, the second vapor pipe 7231, and the second liquid pipe 7232 of the second heat dissipation member 720 may be placed on the fourth seating portion 623 of the second housing 620. In an embodiment, referring to FIG. 11, the fourth heat exchanger 722 may be placed on the first surface 621A of the second inner wall 621 located on the fourth seating portion 623. At least a portion of the second vapor pipe 7231 may be placed on the second surface 611B of the second inner wall 621. The second liquid pipe 7232 may be at least partially placed on the third surface 621C of the second inner wall 621 and the second partition wall 624. Accordingly, as illustrated in FIG. 11, compared to the case of being in contact only with the first heat dissipation member 710, the first electronic component placed on the seating portion 612 is in contact with the first heat dissipation member 710 and the second heat dissipation member 720, thereby increasing the area where heat is distributed and improving heat dissipation efficiency.

In an embodiment not illustrated in the drawings, the third heat exchanger 721 of the second heat dissipation member 720 may be located on the third seating portion 622 to be in contact with the third electronic component. The fourth heat exchanger 722 may be placed on the first surface 621A of the second inner wall 621 located on the fourth seating portion 623. The second vapor pipe 7231 may be placed on the second surface 621B of the second inner wall 621 and the second partition wall 624. The second liquid pipe 7232 may be placed on the third surface 621C of the second inner wall 621 and the second partition wall 624. In an embodiment, the fourth heat exchanger 722, the second vapor pipe 7231, and the second liquid pipe 7232 may face the fourth electronic component. In an embodiment, the fourth heat exchanger 722, the second vapor pipe 7231, and the second liquid pipe 7232 may be in contact with the fourth electronic component or may be attached to the fourth electronic component via an adhesive member.

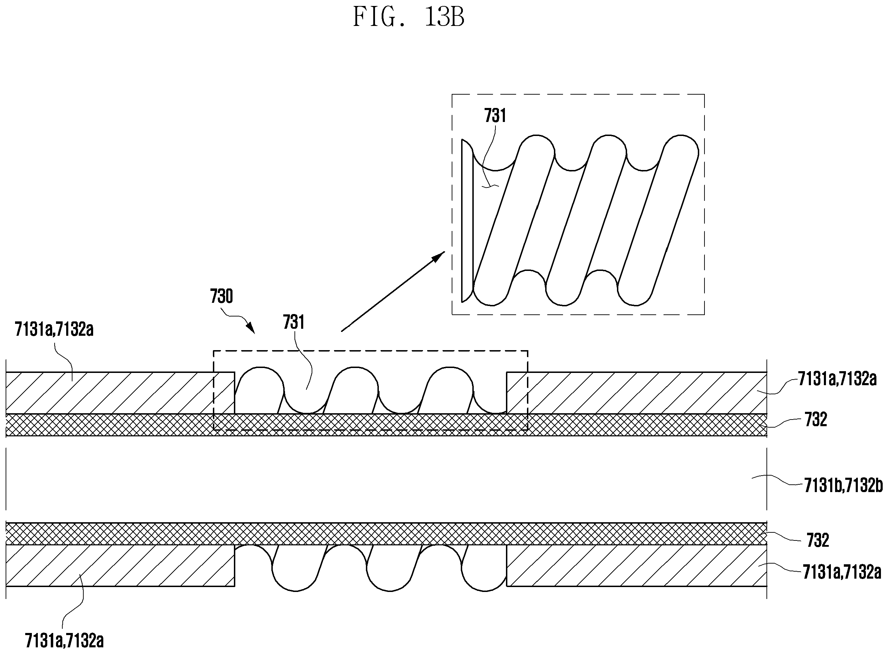

According to an embodiment, as illustrated in FIG. 11, the second heat dissipation member 720 may include a connection portion 730 at least partially located in the folding area of the display and folded together with the electronic device 600. In an embodiment, the connection portion 730 may be configured to interconnect the third heat exchanger 721 and the second vapor pipe 7231 and interconnect the fourth heat exchanger 722 and the second liquid pipe 7232. In an embodiment, the connection portion 730 may be a portion of the second vapor pipe 7231 and/or a portion of the second liquid pipe 7232. For example, the connection portion 730 may be an area located in a folding area of an area of the second vapor pipe 7231. Alternatively, the connection portion 730 may be an area located in a folding area of an area of the second liquid pipe 7232. Referring to FIGS. 13A and 13B, which will be described later, the connection portion 730 may include grooves 731 in a predetermined pattern. The connection portion 730 may be folded or unfolded together with the electronic device 600 due to the grooves 731 provided in the predetermined pattern.

According to an embodiment, as illustrated in FIGS. 12A and 12B, the first heat dissipation member 710 may be placed in the first housing 610 and the second housing 620.

In an embodiment, referring to FIG. 12A, the first heat dissipation member 710 may be placed on the first seating portion 612 of the first housing 610, the second seating portion 613 of the first housing 610, and the fourth seating portion 623 of the second housing 620. In an embodiment, the first heat exchanger 711 of the first heat dissipation member 710 may be placed on the first seating portion 612 to be in contact with the first electronic component. In an embodiment, the second heat exchanger 712 may be placed on the third surface 621C of the second inner wall 621. The first vapor pipe 7131 may be placed on the first partition wall 614 of the first housing 610, the first surface 611A of the first inner wall 611, the second surface 611B of the first inner wall 611, the third surface 611C of the first inner wall 611, the first surface 621A of the second inner wall 621 of the second housing 620, and the second surface 621B of the second inner wall 621. The first liquid pipe 7132 may be placed on the second partition wall 624. The above-described arrangement structure of the first heat dissipation member 710 is merely an example and may be modified in various ways within the scope that can be implemented by a person ordinarily skilled in the art.

In an embodiment, referring to FIG. 12B, the first heat exchanger 711 of the first heat dissipation member 710 may be placed on the first seating portion 612 to be in contact with the first electronic component. In an embodiment, the second heat exchanger 712 may be placed on the third surface 621C of the second inner wall 621. The first vapor pipe 7131 may be placed on the first partition wall 614 of the first housing 610, the first surface 611A of the first inner wall 611, the second surface 611B of the first inner wall 611, and the first surface 621A of the second inner wall 621. The first liquid pipe 7132 may be placed on the second partition wall 624. The above-described arrangement structure of the first heat dissipation member 710 is merely an example and may be modified in various ways within the scope that can be implemented by a person ordinarily skilled in the art.

According to an embodiment of the disclosure, as illustrated in FIGS. 12A and 12B, the first heat dissipation member 710 may be placed in the first housing 610 and the second housing 620. In this case, compared to the case where the first heat dissipation member 710 is placed only in the first housing 610, the area where heat from the first electronic component placed on the first seating portion 612 is diffused increases so that heat dissipation efficiency can be improved.

According to an embodiment, as illustrated in FIGS. 12A and 12B, the first heat dissipation member 710 may include a connection portion 730 at least partially located in the folding area of the display and folded together with the electronic device 600. In an embodiment, the connection portion 730 may be configured with portions of the first vapor pipe 7131 and the first liquid pipe 7132. For example, the connection portion 730 may be an area located in the folding area of an area of the first vapor pipe 7131. In addition, the connection portion 730 may be an area located in the folding area of an area of the first liquid pipe 7132. Referring to FIGS. 13A and 13B, which will be described later, the connection portion 730 may include grooves 731 in a predetermined pattern. The connection portion 730 may be folded or unfolded together with the electronic device 600 due to the grooves 731 provided in the predetermined pattern.

According to an embodiment, the connection portion 730 may be a portion of a configuration of the first heat dissipation member 710 and/or the second heat dissipation member 720 (e.g., the first heat exchanger 711, the second heat exchanger 712, the third heat exchanger 721, the fourth heat exchanger 722, the first vapor pipe 7131, the second vapor pipe 7231, the first liquid pipe 7132, and the second liquid pipe 7232) to be folded together with a folding area. Hereinafter, for convenience of description, as illustrated in FIGS. 12A and 12B, it is assumed that the connection portion 730 is provided in the first vapor pipe 7131 and the first liquid pipe 7132 of the first heat dissipation member 710. However, the disclosure may not be limited to this, and as illustrated in FIG. 11, the connection portion 730 may be provided in the second vapor pipe 7231 and/or the second liquid pipe 7232 of the second heat dissipation member 720.

In an embodiment, referring to FIG. 13A, the connection portion 730 may include a plurality of grooves 731 extending in a direction parallel to the folding axis of the electronic device 600. In an embodiment, the plurality of grooves 731 may be fabricated by processing the outer surface 7131a of the first vapor pipe 7131 or the outer surface 7132a of the first liquid pipe 7132 made of a metal material. In an embodiment, referring to FIG. 13B, the connection portion 730 may include grooves 731 extending in a direction inclined at a predetermined angle with respect to the folding axis of the electronic device 600. In an embodiment, with the connection portion 730, it is possible to ensure the flexibility to be folded or unfolded together with the electronic device 600 due to the plurality of grooves 731.

In an embodiment, referring to FIGS. 13A and 13B, a wick structure 732 may be placed in the conduit 7131b of the first vapor pipe 7131. The wick structure 732 may be a net-shaped mesh structure made of metal. In an embodiment, the first vapor pipe 7131 may move vapor to the second heat exchanger 712 through capillary action by the wick structure 732. In an embodiment, the wick structure 732 may be placed in the conduit 7132b of the first liquid pipe 7132. The first liquid pipe 7132 may move liquid to the first heat exchanger 711 through capillary action by the wick structure 732.

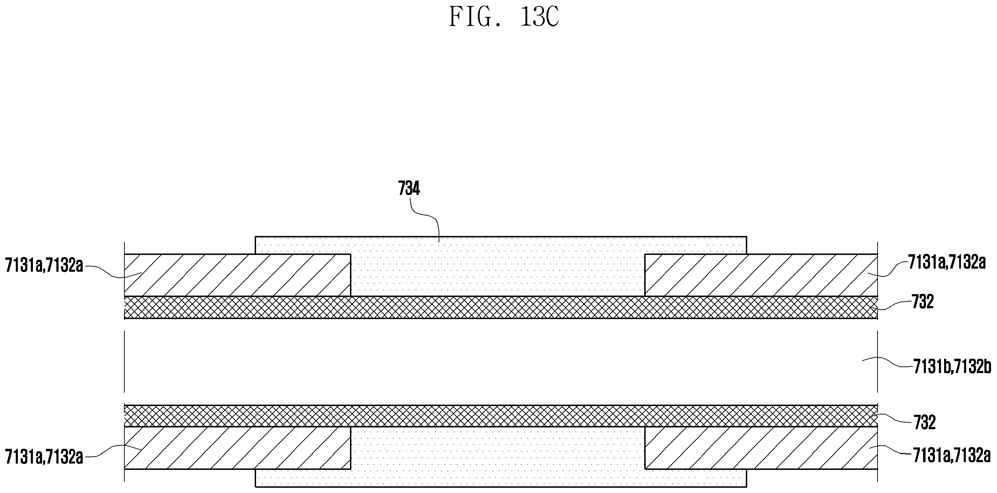

In an embodiment, referring to FIG. 13C, a cover 734 may be placed on the connection portion 730 to cover the grooves 731 in the connection portion 730. In an embodiment, the cover 734 may be made of a polymer material 734 such as silicone or polyurethane. In an embodiment, the cover 734 may be placed on the connection portion 730 of the first vapor pipe 7131 to block vapor from leaking out. In an embodiment, the cover 734 may be placed on the connection portion 730 of the first liquid pipe 7132 to block vapor from leaking out.

According to an embodiment, the diameters of the first vapor pipe 7131 and the first liquid pipe 7132 of the first heat dissipation member 710 and the second vapor pipe 7231 and the second liquid pipe 7232 of the second heat dissipation member 720 may be determined based on the bending radii of the first vapor pipe 7131, the first liquid pipe 7132, the second vapor pipe 7231, and the second liquid pipe 7232 in the connection portion 730. In an embodiment, as illustrated in FIGS. 12A and 12B, when a portion (e.g., the connection portion 730) of the first vapor pipe 7131 and the first liquid pipe 7132 is folded in the folding area, the diameters of the first vapor pipe 7131 and the first liquid pipe 7132 may be about 1/3 times the predetermined bending radii of the first vapor pipe 7131 and the first liquid pipe 7132. In an embodiment, when a portion (e.g., the connection portion 730) of the second vapor pipe 7231 and the second liquid pipe 7232 is folded in the folding area, the diameters of the second vapor pipe 7231 and the second liquid pipe 7232 may be about 1/3 times the predetermined bending radii of the first vapor pipe 7131 and the first liquid pipe 7132.

According to an embodiment, as illustrated in FIG. 14, the first heat dissipation member 710 placed in the first housing 610 and the second heat dissipation member 720 placed in the second housing 620 may be connected to each other via a third heat dissipation member 740 located in the folding area. **In** an embodiment, the third heat dissipation member 740 may be made of a metal material to thermally interconnect the first heat dissipation member 710 and the second heat dissipation member 720. **In** this case, the heat of the first electronic component diffused into the first heat dissipation member 710 may be transferred to the second heat dissipation member 720 via the third heat dissipation member 740. Accordingly, the area where heat generated from the first electronic component is diffused increases so that the heat dissipation efficiency of the electronic device 600 can be improved.

An electronic device according to various embodiments disclosed herein may be any of various types of devices. The electronic device may include, for example, a portable communication device (e.g., a smartphone), a computer device, a portable multimedia device, a portable medical device, a camera, a wearable device, or a home appliance. The electronic device according to an embodiment disclosed herein is not limited to the above-described devices.

The term "module" used in various embodiments of the disclosure may include a unit implemented in hardware, software, or firmware, and may be used interchangeably with terms such as "logic", "logic block", "component", "circuit", or the like. The module may be an integrally configured component or a minimum unit or a portion of the component, which performs one or more functions. For example, according to an embodiment, the module may be implemented in the form of an application-specific integrated circuit (ASIC).

Various embodiments disclosed herein may be implemented by software (e.g., the program 140) including one or more instructions stored in a storage medium (e.g., internal memory 136 or external memory 138) readable by a machine (e.g., the electronic device 101). For example, a processor (e.g., the processor 120) of a device (e.g., the electronic device 101) may call and execute at least one of the stored one or more instructions from the storage medium. This enables the device to be operated to perform at least one function in response to the at least one called instruction. The one or more instructions may include codes generated by a compiler or code capable of being executed by an interpreter. The machine-readable storage medium may be provided in the form of a non-transitory storage medium. Here, the term "non-transitory" merely means that the storage medium is a tangible device and does not contain a signal (e.g., electromagnetic waves), and this term is not intended to distinguish a case where data is permanently stored on the storage medium and a case where data is temporarily stored.

According to an embodiment, a method according to various embodiments disclosed herein may be included and provided in a computer program product. The computer program product may be traded as a product between a seller and a purchaser. The computer program product may be distributed in the form of a machine-readable storage medium (e.g., compact disc read-only memory (CD-ROM)), or may be directly distributed through an application store (e.g., Play Store^{™}), directly between two user devices (e.g., smartphones), or may be distributed online (e.g., downloaded or uploaded). In the case of online distribution, at least part of the computer program product may be temporarily stored in or temporarily produced from a machine-readable storage medium such as a manufacturer's server, a server of an application store, or memory of a relay server.

According to various embodiments, each of the above-described components (e.g., module or program) may include a single object or a plurality of objects, and some of the plurality of objects may be separated and placed in other components. According to various embodiments, one or more of the components or operations described above may be omitted, or one or more other components or operations may be added. Alternatively or additionally, a plurality of components (e.g., modules or programs) may be integrated into one component. In such a case, an integrated component may perform one or more functions of each of the plurality of components in the same or similar manner as when performed by the corresponding one of the plurality of components prior to the integration. According to various embodiments, operations performed by a module, a program, or other components may be performed sequentially, in parallel, repetitively, or heuristically, one or more of the operations may be performed in a different order or omitted, or one or more other operations may be added thereto.

It will be understood that, in addition to the above-disclosed embodiments, the disclosure also contemplates and includes embodiments based on combinations of any two or more of the above-disclosed embodiments and embodiments including any combination of the above-described features. As disclosed herein, the absence of explicit indication that two features may be combined or two embodiments may be combined does not mean that such combinations are not contemplated, but such combinations should be considered as being included herein.

According to an embodiment of the disclosure, an electronic device 400 (e.g., the electronic device 101 in FIG. 1, the electronic device 200 in FIG. 2A, the electronic device 300 in FIG. 3, and/or the electronic device 600 in FIG. 10) may include a first housing 410 (e.g., the first housing 610 in FIG. 10) including a front surface 410A (e.g., the front surface 210A in FIG. 2A), a rear surface 410B (e.g., the rear surface 210B in FIG. 2B) opposite to the front surface, a side surface 410C (e.g. the side surface 210C in FIG. 2A) surrounding the space between the front surface and the rear surface, and a first inner wall 421 (e.g., the first inner wall 611) facing an inner space. In addition, the electronic device may include a first seating portion 422 (e.g., the first seating portion 612 in FIG. 10) which is provided in the first housing and on which a first electronic component is placed. In addition, the electronic device may include a second seating portion 423 (e.g., the second seating portion 613 in FIG. 10) which is provided in the first housing and on which a second electronic component is placed. In addition, the electronic device may include a first partition wall 424 (e.g., the first partition wall 614 in FIG. 10) which extends from the first inner wall and partitions the first seating portion and the second seating portion, and a first heat dissipation member 510 (e.g., the first heat dissipation member 710 in FIG. 10) including a first heat exchanger 511 (e.g., the first heat exchanger 711 in FIG. 10) which is located on the first seating portion to be in contact with the first electronic component, a second heat exchanger 512 (e.g., the second heat exchanger 712 in FIG. 10) which is located in the second seating portion, and a first conduit 513 (e.g., the first conduit 713 in FIG. 10) which is at least partially placed on the first partition wall and the first inner wall to interconnect the first heat exchanger and the second heat exchanger.

In addition, one of the first seating portion and the second seating portion may face the front surface of the electronic device, and the remaining one of the first seating portion and the second portion may face the rear surface of the electronic device, and the first housing may include a first opening 431 which interconnects the front surface and the rear surface of the electronic device and through which a portion of the first heat dissipation member passes.

In addition, the first seating portion and the second seating portion may be provided in the first housing to face either a front surface or a rear surface of the electronic device, and the first partition wall may include a second opening 432 (e.g., the second opening 616 in FIG. 10) which interconnects the first seating portion and the second seating portion and through which a portion of the first heat dissipation member passes.

In addition, the first heat exchanger of the first heat dissipation member may be configured to convert liquid into vapor with heat transferred from the first electronic component, the second heat exchanger of the first heat dissipation member may be configured to convert the vapor generated in the first heat exchanger into liquid, and the first conduit may include a first vapor pipe 5131 (e.g., the first vapor pipe 7131 in FIG. 10) configured to transfer the vapor generated in the first heat exchanger to the second heat exchanger and a first liquid pipe 5132 (e.g., the first liquid pipe 7132 in FIG. 10) configured to transfer the liquid generated in the second heat exchanger to the first heat exchanger.

In addition, the first inner wall may include a first surface 421A (e.g., the first surface 611A in FIG. 10) which faces the first partition wall and on which the second heat exchanger is placed, a second surface 421B (e.g., the second surface 611B in FIG. 10) which is located between the partition wall and the first surface and on which the first vapor pipe is placed, and a third surface 421C (e.g., the third surface 611C in FIG. 10) which faces the second surface and on which the first liquid pipe is placed.

In addition, one surface of at least one of the second heat exchanger, the first vapor pipe, and the first liquid pipe may be configured as a flat surface.

In addition, the second heat exchanger, the first vapor pipe, and the first liquid pipe may have circular cross-sections.

In addition, the second heat exchanger, the first vapor pipe, and the first liquid pipe may face the second electronic component.

In addition, the first heat exchanger of the first heat dissipation member may include a contact portion 5111 which is in contact with the first electronic component, a compensation chamber 5112 through which the liquid generated in the second heat exchanger is transferred, and a blocking portion 5114 which partitions the compensation chamber and the contact portion.

In addition, at least one of the contact portion, the vapor pipe, and the liquid pipe of the first heat exchanger may include a wick structure 5113 located therein.

In addition, the electronic device may further include a second housing 620 rotatably connected to the first housing including a front surface, a rear surface opposite to the front surface, a side surface surrounding the space between the front surface and the rear surface, and a second inner wall 621 which faces the internal space, and a display 330 (e.g., the display 160 in FIG. 1 and/or the display 201 in FIG. 2A) disposed on front surfaces of the first housing and the second housing and including a folding area in which a partial area is deformed by rotation of the second housing relative to the first housing.

In addition, the electronic device may further include a third seating portion 622 which is provided in the second housing and on which a third electronic component is placed, a fourth seating portion 623 which is provided in the second housing and on which a fourth electronic component is placed, a second partition wall 624 which extends from the second inner wall and partitions the third seating portion and the fourth seating portion, and a second heat dissipation member 720 including a third heat exchanger 721 which is located in the third seating portion to be in contact with the third electronic component, a fourth heat exchanger 722 which is located in the fourth seating portion, and a second conduit 723 which is at least partially placed on the second partition wall and the second inner wall to interconnect the third heat exchanger and the fourth heat exchanger.

In addition, the third heat exchanger of the second heat dissipation member may be configured to convert liquid into vapor with heat transferred from the third electronic component, the fourth heat exchanger of the second heat dissipation member may be configured to convert the vapor generated in the third heat exchanger into liquid, and the second conduit may include a second vapor pipe 7231 which transfers the vapor generated in the third heat exchanger to the fourth heat exchanger and a second liquid pipe 7232 which transfers the liquid generated in the fourth heat exchanger to the third heat exchanger.

In addition, the electronic device may further include a third seating portion 622 which is provided in the second housing and on which the third electronic component is placed, a fourth seating portion 623 which is provided in the second housing and on which the fourth electronic component is placed, a second partition wall 624 which extends from the second inner wall and partitions the third seating portion and the fourth seating portion, and a second heat dissipation member 720 including a third heat exchanger 721 which is located on the first seating portion to be in contact with the first electronic component, a fourth heat exchanger 722 which is located in the fourth seating portion, and a second conduit 723 which is at least partially placed on the second partition wall and the second inner wall to interconnect the third heat exchanger and the fourth heat exchanger.

In addition, at least one of the first heat dissipation member and the second heat dissipation member may include a connection portion 730 which is at least partially located in the folding area.

In addition, the connection portion may include a groove 731 extending in a direction parallel to a folding axis of the electronic device.

In addition, the connection portion may include a groove 731 extending in a direction inclined at a predetermined angle with respect to the folding axis of the electronic device.

In addition, the electronic device may further include a cover 734 which is made of a polymer material and covers the connection portion.

Furthermore, the electronic device may further include a second heat dissipation member 720 placed in the second housing, and a third heat dissipation member 740 which is formed of a metal material and at least partially located in the folding area, and interconnects the first heat dissipation member and the second heat dissipation member.

According to an embodiment of the disclosure, an electronic device (e.g., the electronic device 101 in FIG. 1, the electronic device 200 in FIG. 2A, the electronic device 300 in FIG. 3, and/or the electronic device 600 in FIG. 10) may include a housing 410 (e.g., the first housing 610 in FIG. 10) including a seating portion 422 (e.g., the first seating portion 612 in FIG. 10) on which an electronic component is placed, a (1-1)^{th} inner wall 421-1 facing the seating portion, a (1-2)^{th} inner wall 421-2 located between the seating portion and the first inner wall, and a (1-3)^{th} inner wall 421-3 facing the (1-2)^{th} inner wall. In addition, the electronic device may include a heat dissipation member 510 (e.g., the first heat dissipation member 710 in FIG. 10) which is at least partially in contact with the first electronic component, and the heat dissipation member may include a first heat exchanger 511 (e.g., the first heat exchanger 711 in FIG. 10) which is in contact with the first electronic component, a second heat exchanger 512 (e.g., the second heat exchanger 712 in FIG. 10) which is located inside the (1-1)^{th} inner wall, a vapor pipe 5131 (e.g., the first vapor pipe 7131 in FIG. 10) which is located inside the (1-2)^{th} inner wall and interconnects the first heat exchanger and the second heat exchanger, and a liquid pipe 5132 (e.g., the first liquid pipe 7132 in FIG. 10) which is located inside the (1-3)^{th} inner wall and interconnects the first heat exchanger and the second heat exchanger.

## Claims

1. An electronic device (101, 200, 300, 400, 600) comprising:
a first housing (410, 610) comprising a front surface (210A, 410A), a rear surface (210B, 410B) opposite to the front surface and a side surface (210C, 410C) surrounding a space between the front surface and the rear surface,
a first electronic component disposed at a first seating portion (422, 612) of the first housing;
a first battery disposed at a second seating portion (423, 613) of the first housing; and
a first heat dissipation member (510,710) comprising:
a first heat exchanger (511, 711) disposed at the first seating portion, the first heat exchanger being, in contact with the first electronic component and adjacent to a first side of the first battery,
a second heat exchanger (512, 712) disposed at the second seating portion and adjacent to a second side of the first battery, the second side being opposite to the first side of the first battery,
a vapor pipe (5131, 7313) disposed at the second seating portion and adjacent to a third side of the first battery, the third side being perpendicular to the first side of the first battery, the vapor pipe being configured to transfer vapor generated at the first heat exchanger to the second heat exchanger, and
a liquid pipe (5132, 7132) disposed at the second seating portion and adjacent to a fourth side of the first battery, the fourth side being opposite to the third side of the first battery, the liquid pipe being configured to transfer liquid generated at the second heat exchanger to the first heat exchanger.

2. The electronic device of claim 1, wherein one of the first seating portion and the second seating portion is formed on the front surface of the first housing, and the other is formed on the rear surface of the first housing, and
wherein the first housing comprises a first opening (431) that connects the front surface and the rear surface and through which a portion of the first heat dissipation member passes.

3. The electronic device of claim 1, wherein the first seating portion and the second seating portion are formed on one of a front surface and a rear surface of the first housing,
wherein the first housing includes a first partition wall (424, 614) that partitions the first seating portion and the second seating portion, and
wherein the first partition wall comprises a second opening (432, 616) that interconnects the first seating portion and the second seating portion and through which a portion of the first heat dissipation member passes.

4. The electronic device of claim 1, wherein the first heat exchanger of the first heat dissipation member comprises a contact portion (5111) which is configured to be in contact with the first electronic component, a compensation chamber (5112) through which the liquid generated in the second heat exchanger is transferred, and a blocking portion (5114) that partitions the compensation chamber and the contact portion.

5. The electronic device of claim 4, wherein at least one of the contact portion, the vapor pipe, and the liquid pipe of the first heat dissipation member comprises a wick structure (5113) located therein.

6. The electronic device of claim **1,** further comprising:
a second housing (620) rotatably connected to the first housing including a front surface, a rear surface opposite to the front surface, a side surface surrounding the space between the front surface and the rear surface, and a inner wall (621) extending from the side surface; and
a display (160, 201, 330) disposed on front surfaces of the first housing and the second housing and comprising a folding area in which a partial area is deformed by rotation of the second housing relative to the first housing;
a third seating portion (622) formed on the second housing and on which a second electronic component is disposed;
a fourth seating portion (623) formed on the second housing and on which a second battery is disposed;
a second partition wall (624) which extends from the inner wall and partitions the third seating portion and the fourth seating portion; and
a second heat dissipation member (720) comprising:
a third heat exchanger (721) disposed at the third seating portion, in contact with the second electronic component and adjacent to a first side of the second battery,
a fourth heat exchanger (722) disposed at the fourth seating portion and adjacent to a second side of the second battery, the second side of the second battery being opposite to the first side of the second battery;
a second conduit (723) which is at least partially disposed at the second partition wall and the inner wall to interconnect the third heat exchanger and the fourth heat exchanger.

7. The electronic device of claim 6, wherein at least one of the first heat dissipation member and the second heat dissipation member comprises a connection portion (730) which is at least partially located in the folding area.

8. The electronic device of claim 7, wherein the connection portion comprises a groove 731 extending in a direction parallel to a folding axis of the electronic device.

9. The electronic device of claim 7, wherein the connection portion comprises a groove 731 extending in a direction inclined at a predetermined angle with respect to the folding axis of the electronic device.

10. The electronic device of claim 8 or 9, further comprising a cover (734) which is made of a polymer material and covers the connection portion.

11. The electronic device of claim 1, further comprising:
a second housing (620) rotatably connected to the first housing including a front surface, a rear surface opposite to the front surface, a side surface surrounding the space between the front surface and the rear surface, and a inner wall (621) extending from the side surface; and
a display (160, 201, 330) disposed on front surfaces of the first housing and the second housing and comprising a folding area in which a partial area is deformed by rotation of the second housing relative to the first housing;
a second heat dissipation member (720) disposed at the second housing, and
a third heat dissipation member (740) which is formed of a metal material and at least partially located in the folding area, and interconnects the first heat dissipation member and the second heat dissipation member.

12. The electronic device of claim 1, wherein at least one of the second heat exchanger, the vapor pipe, and the liquid pipe is in contact with the first battery.

## Patentansprüche

1. Elektronische Vorrichtung (101, 200, 300, 400, 600), die Folgendes umfasst:
ein erstes Gehäuse (410, 610), das eine Vorderseite (210A, 410A), eine Rückseite (210B, 410B), die der Vorderseite gegenüberliegt, und eine Seitenfläche (210C, 410C) umfasst, die einen Raum zwischen der Vorderseite und der Rückseite umgibt,
eine erste elektronische Komponente, die an einem ersten Aufnahmebereich (422, 612) des ersten Gehäuses angeordnet ist;
eine erste Batterie, die an einem zweiten Aufnahmebereich (423, 613) des ersten Gehäuses angeordnet ist; und
ein erstes Wärmeableitungselement (510, 710), das Folgendes umfasst:
einen ersten Wärmetauscher (511, 711), der an dem ersten Aufnahmebereich angeordnet ist, wobei der erste Wärmetauscher mit der ersten elektronischen Komponente in Kontakt steht und an eine erste Seite der ersten Batterie angrenzt,
einen zweiten Wärmetauscher (512, 712), der an dem zweiten Aufnahmebereich angeordnet ist und an eine zweite Seite der ersten Batterie angrenzt, wobei die zweite Seite der ersten Seite der ersten Batterie gegenüberliegt,
ein Dampfrohr (5131, 7313), das am zweiten Aufnahmebereich angeordnet ist und an eine dritte Seite der ersten Batterie angrenzt, wobei die dritte Seite senkrecht zur ersten Seite der ersten Batterie steht und das Dampfrohr konfiguriert ist, um den am ersten Wärmetauscher erzeugten Dampf zum zweiten Wärmetauscher zu leiten, und
ein Flüssigkeitsrohr (5132, 7132), das am zweiten Aufnahmebereich angeordnet ist und an eine vierte Seite der ersten Batterie angrenzt, wobei die vierte Seite der dritten Seite der ersten Batterie gegenüberliegt und das Flüssigkeitsrohr konfiguriert ist, um die am zweiten Wärmetauscher erzeugte Flüssigkeit zum ersten Wärmetauscher zu leiten.

2. Elektronische Vorrichtung nach Anspruch 1, wobei entweder der erste Aufnahmebereich oder der zweite Aufnahmebereich an der Vorderseite des ersten Gehäuses ausgebildet ist und der andere an der Rückseite des ersten Gehäuses ausgebildet ist, und
wobei das erste Gehäuse eine erste Öffnung (431) umfasst, die die Vorderseite und die Rückseite verbindet und durch die ein Abschnitt des ersten Wärmeableitungselements verläuft.

3. Elektronische Vorrichtung nach Anspruch 1, wobei der erste Aufnahmebereich und der zweite Aufnahmebereich an der Vorderseite oder der Rückseite des ersten Gehäuses ausgebildet sind,
wobei das erste Gehäuse eine erste Trennwand (424, 614) aufweist, die den ersten Aufnahmebereich und den zweiten Aufnahmebereich voneinander trennt, und
wobei die erste Trennwand eine zweite Öffnung (432, 616) umfasst, die den ersten Aufnahmebereich und den zweiten Aufnahmebereich miteinander verbindet und durch die ein Abschnitt des ersten Wärmeableitungselements verläuft.

4. Elektronische Vorrichtung nach Anspruch 1, wobei der erste Wärmetauscher des ersten Wärmeableitungselements einen Kontaktabschnitt (5111), der konfiguriert ist, um mit der ersten elektronischen Komponente in Kontakt zu stehen, eine Ausgleichskammer (5112), durch die die im zweiten Wärmetauscher erzeugte Flüssigkeit geleitet wird, und einen Trennabschnitt (5114) umfasst, der die Ausgleichskammer und den Kontaktabschnitt voneinander trennt.

5. Elektronische Vorrichtung nach Anspruch 4, wobei der Kontaktabschnitt, das Dampfrohr und/oder das Flüssigkeitsrohr des ersten Wärmeableitungselements eine darin angeordnete Dochtstruktur (5113) umfassen.

6. Elektronische Vorrichtung nach Anspruch 1, die ferner Folgendes umfasst:
ein zweites Gehäuse (620), das drehbar mit dem ersten Gehäuse verbunden ist und eine Vorderseite, eine der Vorderseite gegenüberliegende Rückseite, eine den Raum zwischen der Vorderseite und der Rückseite umgebende Seitenfläche sowie eine sich von der Seitenfläche erstreckende Innenwand (621) aufweist; und
ein Display (160, 201, 330), das an den Vorderseiten des ersten Gehäuses und des zweiten Gehäuses angeordnet ist und einen Faltbereich umfasst, in dem ein Teilbereich durch Drehung des zweiten Gehäuses relativ zum ersten Gehäuse verformt wird;
einen dritten Aufnahmebereich (622), der an dem zweiten Gehäuse ausgebildet ist und auf dem eine zweite elektronische Komponente angeordnet ist;
einen vierten Aufnahmebereich (623), der an dem zweiten Gehäuse ausgebildet ist und auf dem eine zweite Batterie angeordnet ist;
eine zweite Trennwand (624), die sich von der Innenwand erstreckt und den dritten Aufnahmebereich und den vierten Aufnahmebereich voneinander trennt; und
ein zweites Wärmeableitungselement (720), das Folgendes umfasst:
einen dritten Wärmetauscher (721), der am dritten Aufnahmebereich angeordnet ist, in Kontakt mit der zweiten elektronischen Komponente steht und an eine erste Seite der zweiten Batterie angrenzt,
einen vierten Wärmetauscher (722), der am vierten Aufnahmebereich angeordnet ist und an eine zweite Seite der zweiten Batterie angrenzt, wobei die zweite Seite der zweiten Batterie der ersten Seite der zweiten Batterie gegenüberliegt;
eine zweite Leitung (723), die zumindest teilweise an der zweiten Trennwand und der Innenwand angeordnet ist, um den dritten Wärmetauscher und den vierten Wärmetauscher miteinander zu verbinden.

7. Elektronische Vorrichtung nach Anspruch 6, wobei das erste Wärmeableitungselement und/oder das zweite Wärmeableitungselement einen Verbindungsabschnitt (730) umfasst, der sich zumindest teilweise im Faltbereich befindet.

8. Elektronische Vorrichtung nach Anspruch 7, wobei der Verbindungsabschnitt eine Nut 731 umfasst, die sich in einer Richtung parallel zu einer Faltachse der elektronischen Vorrichtung erstreckt.

9. Elektronische Vorrichtung nach Anspruch 7, wobei der Verbindungsabschnitt eine Nut 731 umfasst, die sich in einer Richtung erstreckt, die in einem vorbestimmten Winkel zur Faltachse der elektronischen Vorrichtung geneigt ist.

10. Elektronische Vorrichtung nach Anspruch 8 oder 9, die ferner eine Abdeckung (734) umfasst, die aus einem Polymermaterial besteht und den Verbindungsabschnitt abdeckt.

11. Elektronische Vorrichtung nach Anspruch 1, die ferner Folgendes umfasst:
ein zweites Gehäuse (620), das drehbar mit dem ersten Gehäuse verbunden ist und eine Vorderseite, eine der Vorderseite gegenüberliegende Rückseite, eine den Raum zwischen der Vorderseite und der Rückseite umgebende Seitenfläche sowie eine sich von der Seitenfläche erstreckende Innenwand (621) aufweist; und
ein Display (160, 201, 330), das an den Vorderseiten des ersten Gehäuses und des zweiten Gehäuses angeordnet ist und einen Faltbereich umfasst, in dem ein Teilbereich durch Drehung des zweiten Gehäuses relativ zum ersten Gehäuse verformt wird;
ein zweites Wärmeableitungselement (720), das am zweiten Gehäuse angeordnet ist, und
ein drittes Wärmeableitungselement (740), das aus einem metallischen Material gebildet ist und sich zumindest teilweise im Faltbereich befindet und das erste Wärmeableitungselement und das zweite Wärmeableitungselement miteinander verbindet.

12. Elektronische Vorrichtung nach Anspruch 1, wobei der zweite Wärmetauscher, das Dampfrohr und/oder das Flüssigkeitsrohr mit der ersten Batterie in Kontakt stehen.

## Revendications

1. Dispositif électronique (101, 200, 300, 400, 600) comprenant :
un premier boîtier (410, 610) comprenant une surface avant (210A ; 410A), une surface arrière (210B, 410B) opposée à la surface avant et une surface latérale (210C, 410C) entourant un espace entre la surface avant et la surface arrière,
un premier composant électronique disposé au niveau d'une première partie d'assise (422, 612) du premier boîtier ;
une première batterie disposée au niveau d'une deuxième partie d'assise (423, 613) du premier boîtier ; et
un premier élément de dissipation de chaleur (510, 710) comprenant :
un premier échangeur de chaleur (511, 711) disposé au niveau de la première partie d'assise, le premier échangeur de chaleur étant en contact avec le premier composant électronique et adjacent à un premier côté de la première batterie,
un second échangeur de chaleur (512, 712) disposé au niveau de la deuxième partie d'assise et adjacent à un deuxième côté de la première batterie, le deuxième côté étant opposé au premier côté de la première batterie,
un tuyau de vapeur (5131, 7313) disposé au niveau de la deuxième partie d'assise et adjacent à un troisième côté de la première batterie, le troisième côté étant perpendiculaire au premier côté de la première batterie, le tuyau de vapeur étant configuré pour transférer au deuxième échangeur de chaleur la vapeur générée au niveau du premier échangeur de chaleur, et
un tuyau de liquide (5132, 7132) disposé au niveau de la deuxième partie d'assise et adjacent à un quatrième côté de la première batterie, le quatrième côté étant opposé au troisième côté de la première batterie, le tuyau de liquide étant configuré pour transférer au premier échangeur de chaleur le liquide généré au niveau du deuxième échangeur de chaleur.

2. Dispositif électronique selon la revendication 1, où l'une parmi la première partie d'assise et la deuxième partie d'assise est formée sur la surface avant du premier boîtier, et l'autre est formée sur la surface arrière du premier boîtier, et
où le premier boîtier comprend une première ouverture (431) qui connecte la surface avant et la surface arrière et à travers laquelle une partie du premier élément de dissipation de chaleur passe.

3. Dispositif électronique selon la revendication 1, où la première partie d'assise et la deuxième partie d'assise sont formées sur l'une parmi une surface avant et une surface arrière du premier boîtier,
où le premier boîtier inclut une première paroi de séparation (424, 614) qui sépare la première partie d'assise et la deuxième partie d'assise, et
où la première paroi de séparation comprend une deuxième ouverture (432, 616) qui interconnecte la première partie d'assise et la deuxième partie d'assise et à travers laquelle une partie du premier élément de dissipation de chaleur passe.

4. Dispositif électronique selon la revendication 1, où le premier échangeur de chaleur du premier élément de dissipation de chaleur comprend une partie de contact (5111) qui est configurée pour être en contact avec le premier composant électronique, une chambre de compensation (5112) à travers laquelle le liquide généré dans le deuxième échangeur de chaleur est transféré, et une partie de blocage (5114) qui sépare la chambre de compensation et la partie de contact.

5. Dispositif électronique selon la revendication 4, où au moins un élément parmi la partie de contact, le tuyau de vapeur, et le tuyau liquide du premier élément de dissipation de chaleur comprend une structure de mèche (5113) située à l'intérieur.

6. Dispositif électronique selon la revendication 1, comprenant en outre :
un deuxième boîtier (620) connecté de façon rotative au premier boîtier incluant une surface avant, une surface arrière opposée à la surface avant, une surface latérale entourant l'espace entre la surface avant et la surface arrière, et une paroi intérieure (621) s'étendant depuis la surface latérale ; et
une unité d'affichage (160, 201, 330) disposée sur les surfaces avant du premier boîtier et du deuxième boîtier et comprenant une zone de pliage dans laquelle une zone partielle est déformée par rotation du deuxième boîtier par rapport au premier boîtier ;
une troisième partie d'assise (622) formée sur le deuxième boîtier et sur laquelle un deuxième composant électronique est disposé ;
une quatrième partie d'assise (623) formée sur le deuxième boîtier et sur laquelle une deuxième batterie est disposée ;
une deuxième paroi de séparation (624) qui s'étend depuis la paroi intérieure et qui sépare la troisième partie d'assise et la quatrième partie d'assise ; et
un deuxième élément de dissipation de chaleur (720) comprenant :
un troisième échangeur de chaleur (721) disposé au niveau de la troisième partie d'assise, en contact avec le deuxième composant électronique et adjacent à un premier côté de la deuxième batterie,
un quatrième échangeur de chaleur (722) disposé au niveau de la quatrième partie d'assise et adjacent à un deuxième côté de la deuxième batterie, le deuxième côté de la deuxième batterie étant opposé au premier côté de la deuxième batterie ;
un deuxième conduit (723) qui est disposé au moins partiellement au niveau de la deuxième paroi de séparation et de la paroi intérieure pour interconnecter le troisième échangeur de chaleur et le quatrième échangeur de chaleur.

7. Dispositif électronique selon la revendication 6, où au moins l'un parmi le premier élément de dissipation de chaleur et le deuxième élément de dissipation de chaleur comprend une partie de connexion (730) qui est au moins partiellement située dans la zone de pliage.

8. Dispositif électronique selon la revendication 7, où la partie de connexion comprend une rainure 731 s'étendant dans une direction parallèle à un axe de pliage du dispositif électronique.

9. Dispositif électronique selon la revendication 7, où la partie de connexion comprend une rainure 731 s'étendant dans une direction inclinée selon un angle prédéterminé par rapport à l'axe de pliage du dispositif électronique.

10. Dispositif électronique selon la revendication 8 ou 9, comprenant en outre un couvercle (734) qui est fait d'un matériau polymère et qui recouvre la partie de connexion.

11. Dispositif électronique selon la revendication 1, comprenant en outre :
un deuxième boîtier (620) connecté de façon rotative au premier boîtier incluant une surface avant, une surface arrière opposée à la surface avant, une surface latérale entourant l'espace entre la surface avant et la surface arrière, et une paroi intérieure (621) s'étendant depuis la surface latérale ; et
une unité d'affichage (160, 201, 330) disposée sur les surfaces avant du premier boîtier et du deuxième boîtier et comprenant une zone de pliage dans laquelle une zone partielle est déformée par rotation du deuxième boîtier par rapport au premier boîtier ;
un deuxième élément de dissipation de chaleur (720) disposé au niveau du deuxième boîtier, et
un troisième élément de dissipation de chaleur (740) qui est formé d'un matériau métallique et au moins partiellement situé dans la zone de pliage, et qui interconnecte le premier élément de dissipation de chaleur et le deuxième élément de dissipation de chaleur.

12. Dispositif électronique selon la revendication 1, où au moins un élément parmi le second échangeur de chaleur, le tuyau de vapeur, et le tuyau de liquide est en contact avec la première batterie.
